(19) Europäisches Patentamt
European Patent Office
Office européen des brevets

(11) **EP 2 237 060 B1**

(12) **EUROPÄISCHE PATENTSCHRIFT**

(45) Veröffentlichungstag und Bekanntmachung des Hinweises auf die Patenterteilung:
**14.01.2015 Patentblatt 2015/03**

(51) Int Cl.:
***G01R 33/58*** *(2006.01)*

(21) Anmeldenummer: **10158259.1**

(22) Anmeldetag: **29.03.2010**

(54) **Verfahren zur Gewinnung von Amplituden- und Phasenverläufen von HF-Pulsen für die räumlich-selektive Anregung**

Method for generating amplitude and phase values of HF pulses for spatial-selective excitation

Procédé de production de déroulements d'amplitudes et de phases d'impulsions HF pour l'excitation spatiale sélective

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.04.2009 DE 102009002112**

(43) Veröffentlichungstag der Anmeldung:
**06.10.2010 Patentblatt 2010/40**

(73) Patentinhaber: **Bruker BioSpin MRI GmbH**
**76275 Ettlingen (DE)**

(72) Erfinder:
• **Schneider, Johannes**
**76135, Karlsruhe (DE)**
• **Ullmann, Peter**
**76137, Karlsruhe (DE)**

(74) Vertreter: **Kohler Schmid Möbus**
**Patentanwälte**
**Ruppmannstraße 27**
**70565 Stuttgart (DE)**

(56) Entgegenhaltungen:
• ULLMANN P ET AL: "Parallel excitation experiments using measured k-space trajectories for pulse calculation" PROCEEDINGS OF THE INTERNATIONAL SOCIETY FOR MAGNETIC RESONANCE IN MEDICINE, 16TH SCIENTIFIC MEETING AND EXHIBITION, TORONTO, CANADA, 3-9 MAY 2008, 19. April 2008 (2008-04-19), Seite 1313, XP002590594
• ZHANG Y ET AL: "A NOVEL K-SPACE TRAJECTORY MEASUREMENT TECHNIQUE" MAGNETIC RESONANCE IN MEDICINE, ACADEMIC PRESS, DULUTH, MN, US, Bd. 39, 1. Juni 1998 (1998-06-01), Seiten 999-1004, XP000922514 ISSN: 0740-3194
• GRISSOM W ET AL: "Spatial domain method for the design of RF pulses in multicoil parallel excitation" MAGNETIC RESONANCE IN MEDICINE, ACADEMIC PRESS, DULUTH, MN, US LNKD- DOI:10.1002/MRM.20978, Bd. 56, Nr. 3, 1. September 2006 (2006-09-01), Seiten 620-629, XP002475615 ISSN: 0740-3194
• OELHAFEN M ET AL: "Calibration of echo-planar 2D-selective RF excitation pulses" MAGNETIC RESONANCE IN MEDICINE, ACADEMIC PRESS, DULUTH, MN, US, Bd. 52, 2004, Seiten 1136-1145, XP002590595
• TAKAHASHI A, PETERS T: "Compensation of multi-dimensional selective excitation pulses using measured k-space trajectories" MAGNETIC RESONANCE IN MEDICINE, ACADEMIC PRESS, DULUTH, MN, US, Bd. 34, 1995, Seiten 446-456, XP002590596
• PAPADAKIS N G ET AL: "A GENERAL METHOD FOR MEASUREMENT OF THE TIME INTEGRAL OF VARIANT MAGNETIC FIELD GRADIENTS: APPLICATION TO 2D SPIRAL IMAGING" MAGNETIC RESONANCE IMAGING, ELSEVIER SCIENCE, TARRYTOWN, NY, US LNKD- DOI: 10.1016/S0730-725X(97)00014-3, Bd. 15, Nr. 5, 1. Januar 1997 (1997-01-01) , Seiten 567-578, XP001153586 ISSN: 0730-725X

- SCHNEIDER JT ET AL: "Coping with off-resonance effects and gradient imperfections in parallel transmission experiments" PROCEEDINGS OF THE INTERNATIONAL SOCIETY FOR MAGNETIC RESONANCE IN MEDICINE, 17TH SCIENTIFIC MEETING AND EXHIBITION, HONOLULU, HAWAII, USA, 18-24 APRIL 2009, 4. April 2009 (2009-04-04), Seite 172, XP002590597

- WU X ET AL: "Parallel excitation in the human brain at 9.4 T counteracting k-space errors with RF pulse design" MAGNETIC RESONANCE IN MEDICINE, ACADEMIC PRESS, DULUTH, MN, US, Bd. 63, 16. Dezember 2009 (2009-12-16), Seiten 524-529, XP002590598

**Beschreibung**

Hintergrund der Erfindung

Die Erfindung betrifft ein Verfahren zur Gewinnung von Amplituden- und Phasenverläufen von Hochfrequenzpulsen, welche im Rahmen eines Hauptexperimentes der magnetischen Resonanz zur Erzeugung einer vorgegebenen n-dimensionalen räumlichen Verteilung (n>=1) der Transversalmagnetisierung in einem Objekt mittels mindestens einer Hochfrequenz-Sendeantenne eines Magnetresonanzmesssystems in Kombination mit räumlich und zeitlich variierenden Zusatzmagnetfeldern, die dem statischen und homogenen Grundfeld des Magnetresonanzmesssystems überlagert werden und die zu einer ortsabhängigen, zeitlichen Änderung der Transversalmagnetisierungsphase im Objekt führen, eingestrahlt werden, wobei vor Durchführung des Hauptexperimentes eine Vorbereitungsmessung in Form einer MR-Messung durchgeführt wird und die Amplituden- und Phasenverläufe der Hochfrequenzpulse für das Hauptexperiment auf Basis der Vorbereitungsmessung berechnet werden, und wobei der räumliche und zeitliche Verlauf der Zusatzmagnetfelder während der Vorbereitungsmessung und dem Hauptexperiment im Wesentlichen Identisch sind.

Ein derartiges Verfahren ist beispielsweise bekannt aus [10].

Die Magnetresonanzbildgebung (MRI: Magnetic Resonance Imaging), auch als Magnetresonanztomographie (MRT) bezeichnet, ist eine weitverbreitete Technik zur nichtinvasiven Gewinnung von Bildern des Innern eines Untersuchungsobjektes und beruht auf der ortsaufgelösten Messung von Magnetresonanzsignalen aus dem Untersuchungsobjekt. Indem das Untersuchungsobjekt innerhalb eines Grundfeldmagneten einem im Wesentlichen statischen und homogenen magnetischen Grundfeld ausgesetzt wird, werden in ihm enthaltene Kemspins bzgl. der Richtung des Grundfeldes, in der Regel als z-Richtung eines magnetgebundenen Koordinatensystems gewählt, orientiert. Die damit verbundene Ausrichtung der magnetischen Dipole der Atomkerne führt zu einer Magnetisierung des Objektes in Richtung des Hauptmagnetfeldes, die als Longitudinalmagnetisierung bezeichnet wird. Bei der MR-Untersuchung (MR: Magnetische Resonanz bzw. magnetic resonance) wird durch Einstrahlung von elektromagnetischen HF-Pulsen (HF: Hochfrequenz) mittels einer oder mehrerer HF-Sendeantennen diese Longitudinalmagnetisierung des Untersuchungsobjekts zu einer Präzessionsbewegung angeregt, deren Frequenz proportional zu der lokalen magnetischen Feldstärke ist. Der Vektor der Magnetisierung wird dabei um einen Winkel, der im Folgenden als Auslenkungswinkel bezeichnet wird, aus der Gleichgewichtslage (z-Richtung) ausgelenkt. Bei den heute allgemein verwendeten MRI-Verfahren wird den Präzessionsbewegungen der Kernspins durch zeitlich variierte Überlagerungen von zusätzlichen Magnetfeldern für alle drei Raumrichtungen eine räumliche Kodierung, im Allgemeinen als Ortskodierung bezeichnet, aufgeprägt. Die hierfür verwendeten sogenannten Gradientenfelder $G_x$, $G_y$ und $G_z$ mit üblicherweise konstanten Gradienten in den Raumrichtungen x, y und z werden von einer als Gradientensystem bezeichneten Spulenanordnung, die für die Raumrichtungen jeweils von einem sog. Gradientenkanal angesteuert werden, erzeugt. Ist im Folgenden von linearen und nichtlinearen Gradienten- oder Magnetfeldern die Rede, ist dies, soweit nicht anders genannt, stets auf den räumlichen Verlauf der Felder bezogen. Die Ortskodierung wird üblicherweise durch ein Schema in einem dem Ortsraum über eine Fouriertransformation konjugierten Raum, dem sog. k-Raum, beschrieben. In diesem k-Raum-Formalismus, der nur bei der Verwendung von Magnetfeldern mit im Raum konstantem Gradienten anwendbar ist, lässt sich das Schalten von Gradientenpulsen als das Durchlaufen einer Trajektorie im k-Raum, der sog. k-Raum-Trajektorie beschreiben. Die Transversalkomponente der mit den Kernspins verbundenen präzedierenden Magnetisierung, im Folgenden auch Transversalmagnetisierung genannt, induziert in einer oder mehreren HF-Empfangsantennen, welche das Untersuchungsobjekt umgeben, Spannungssignale, die auch als Magnetresonanzsignale (MR-Signale) bezeichnet werden. Mittels Pulssequenzen, welche speziell gewählte Abfolgen von HF-Pulsen und Gradientenpulsen (kurzzeitiges Anlegen von zeitlich konstanten oder veränderlichen Gradientenfeldern) enthalten, werden zeitlich veränderliche Magnetresonanzsignale derart erzeugt, dass sie in entsprechende räumliche Abbildungen umgesetzt werden können. Dies erfolgt nach einer von vielen wohlbekannten Rekonstruktionstechniken, nachdem die MR-Signale mittels eines elektronischen Empfangssystems aufgenommen, verstärkt und digitalisiert, sowie mittels eines elektronischen Rechnersystems verarbeitet und in ein- oder mehrdimensionale Datensätze abgespeichert worden sind. Typischerweise enthält die verwendete Pulssequenz eine Abfolge von Messabläufen, in denen die Gradientenpulse gemäß dem gewählten Lokalisierungsverfahren variiert werden.

Eine wesentliche Voraussetzung für eine ortsgetreue Abbildung der Kernspins des Untersuchungsobjektes ist, dass die technischen Imperfektionen des MR-Messsystems vernachlässigbar oder die Abweichungen vom idealen Verhalten bekannt sind und entsprechend korrigiert werden können.

Die räumlich selektive Anregung ist eine in der Magnetresonanzbildgebung weit verbreitete Technik, welche dazu genutzt wird, die bei der Anregung erzeugte Transversalmagnetisierung räumlich einzuschränken und/oder deren Amplitude und Phase im Anregungsvolumen, vorgegebenen Verteilungen entsprechend, räumlich zu variieren. Bei der Schichtselektion, dem häufigsten Fall der räumlich selektiven Anregung, wird das Anregungsvolumen auf eine vorgegebene Schicht reduziert. Die mehrdimensionale räumlich selektive Anregung, bei welcher das Anregungsvolumen in mehr als einer Richtung eingeschränkt und/oder die Anregung in mehr als einer Richtung moduliert wird, hat ebenfalls zahlreiche Anwendungen hervorgebracht. Zu nennen sind hier die Anregung eines kleinen dreidimensionalen Volumens innerhalb eines wesentlich größeren Untersuchungsobjektes für lokalisierte Spektroskopie, die Abbildung einer selektiv angeregten Region (ROI: Region of Interest) mit reduziertem Sichtfeld (FOV: Field of View) mit dem Ziel der Messzeitverkürzung oder Auflösungsverbesserung, die Anregung spezieller, an Strukturen des Untersuchungsobjekts angepasster Volumina oder auch die echo-planare Bildgebung mit reduzierten Echozuglängen. Weiterhin kann die Amplituden- und Phasenmodulation der Transversalmagnetisierung bei der Anregung auch dazu genutzt werden, um nachteilige Effekte eines inhomogenen magnetischen Sendefeldes ($B_1$-Feld) der zum Anregen verwendeten HF-Antennen zu kompensieren. Dies ist eine Anwendung, welche heutzutage aufgrund der starken Zunahme von Hochfeld-MRI-Systemen, an welchen derartige Inhomogenitäten besonders auftreten, immens an Bedeutung gewonnen hat.

Im Regelfall wurde die räumlich selektive Anregung in der Vergangenheit mittels einer einzelnen HF-Sendeantenne mit einem im Wesentlichen homogenen Sendefeld ($B_1$-Feld) in Kombination mit dem Gradientensystem durchgeführt. Inspiriert durch den Erfolg der Parallelen Bildgebung, bei welcher die Signalaufnahme mit einer Anordnung von mehreren HF-Empfangsantennen, in der Fachliteratur auch als Antennenarray, bestehend aus mehreren Einzelantennen oder Elementen,bezeichnet, durchgeführt wird, ist man inzwischen dazu übergegangen, auch bei der selektiven Anregung solche, aus mehreren Elementen bestehende Antennenarrays, betrieben an mehreren HF-Sendekanälen des MR-Messsystems, zum Senden einzusetzen. Damit ist man in der Lage, die Ortskodierung, welche bei der selektiven Anregung in Analogie zur Akquisition durch Variation von Gradientenfeldern realisiert wird, partiell durch sog. Sensitivitätskodierung zu ersetzen und damit die Länge der Anregungspulse zu reduzieren. Dies bedeutet, dass man die Information ausnutzt, welche in den unterschiedlichen räumlichen Variationen der Sendefelder der einzelnen Arrayelemente, im Folgenden auch als Sendeprofile bezeichnet, enthalten ist. Da die Länge solcher selektiver Anregungspulse meist eines der limitierenden Kriterien für die Anwendbarkeit dieser Technik war, ist die sog. Parallele Anregung (PEX: Parallel Excitation) oder mehrkanalige Anregung ein viel versprechender Ansatz, um räumlich selektive Anregung in noch breiterer Weise einzusetzen als bisher geschehen. Die Ortskodierung während des Sendens von HF-Pulsen zum Zweck der selektiven Anregung wird im Folgenden Sendeortskodierung genannt, um sie von der Ortskodierung im Akquisitionsfall zu unterschieden.

Eine der Grundaufgaben beim Einsatz selektiver Anregung ist die Bestimmung der HF-Pulse, welche vom HF-Sendesystem des MR-Messsystems abgespielt werden müssen, um in Kombination mit Zusatzmagnetfeldern die gewünschte Verteilung der Transversalmagnetisierung zu generieren. Im Artikel "A k-space analysis of small tip-angle excitation" [1] beschreiben Pauly et al. ein Verfahren für die einkanalige räumlich selektive Anregung, mit welchem die gesuchte Pulsform $B_1(t)$ aufgrund einer mathematischen Analogie der selektiven Anregung mit der Fourier-Bildgebung im Wesentlichen durch Fouriertransformation der gewünschten Transversalmagnetisierungsverteilung und Abtastung der Fouriertransformierten entlang einer vorgegebenen k-Raum-Trajektorie berechnet werden kann. Katscher et al. erweiterten dieses Berechnungsverfahren für den Fall eines Antennenarrays mit mehreren unabhängigen Sendekanälen [2].

Oftmals enthält ein Objekt mehrere Kernspinspezies mit voneinander verschiedenen Präzessionsfrequenzen, wie sie bei Kernen unterschiedlicher chemischer Elemente oder gleichartiger Kerne in unterschiedlichen chemischen Umgebungen, auftreten. Die Kernspinspezies lassen sich zu Kernspinensembles gleicher Larmorfrequenz, die jeweils einen Beitrag zur gesamten Transversalmagnetisierung leisten, zusammenfassen. Da die nach Pauly et al. oder Katscher et al. ermittelten HF-Pulse im Allgemeinen nur für mit einer bestimmten Frequenz präzedierende Kernspins optimal bezüglich der Realisierungstreue der gewünschten Transversalmagnetisierungsverteilung sind, werden mit diesen HF-Pulsen für die Transversalmagnetisierungsbeiträge der einzelnen Kernspinensembles unterschiedliche, im Allgemeinen unbeabsichtigte, Verteilungen angeregt. Meyer et al. [3] oder Setsompop [4] stellten daher beispielsweise Verfahren vor, mit denen die räumlich selektive Anregung ebenfalls selektiv für Kernspinensembles mit ausgewählter Präzessionsfrequenz erfolgen kann. Man spricht in diesem Fall von räumlich spektral selektiver Anregung unter Verwendung von räumlich spektral selektiven HF-Pulsen. Mit diesem Ansatz ist es auch möglich, für die Transversalmagnetisierungsbeiträge der einzelnen Kernspinensembles individuelle Verteilungen, die untereinander verschieden oder gleich sein können, vorzugeben und mit einem oder mehreren HF-Pulsen anzuregen. Sofern nicht die spektrale Selektivität besonders betont werden soll, wird im Folgenden auch weiter von räumlich selektiver Anregung oder selektiver Anregung gesprochen.

Grundlage für die Berechnungsverfahren der zur selektiven Anregung verwendeten HF-Pulse sind im Allgemeinen die wohlbekannten Blochgleichungen zur Beschreibung der Entwicklung der Magnetisierung in einem Objekt während der Einwirkung äußerer Magnetfelder. Betrachtet man nur den Fall, dass äußere Felder die Probenmagnetisierung lediglich um kleine Winkel aus der Gleichgewichtslage (z-Richtung) auslenken, was im Folgenden als Kleinwinkelnäherung (Small-Tip-Angle Approximation) bezeichnet wird, so lässt sich die Verteilung der als komplexe Größe beschriebenen Transversalmagnetisierung in der x-y-Ebene nach folgender Gleichung berechnen (unter Vernachlässigung von Relaxationseffekten):

$$M_{xy}(\mathbf{x}) = i\gamma\, M_0 \sum_n^N S_n(\mathbf{x}) \int_0^T B_{1,n}(t)\, e^{i\,\varphi(\mathbf{x},t)}\, dt \qquad (1)$$

$M_{xy}$ ist die erzeugte Transversalmagnetisierungsverteilung, x bezeichnet die Ortskoordinate, y das gyromagnetische Verhältnis der untersuchten Spinspezies, $M_0$ die Gleichgewichtsmagnetisierung (das magnetische Grundfeld ist in z-Richtung orientiert), $B_{1,n}$ den der Sendeantenne n von $N$ zugeführte HF-Puls , $S_n$ die räumliche Variation des Sendefeldes von Arrayelement $n$, φ die Phase, die die Transversalmagnetisierung ab dem Zeitpunkt ihrer Erzeugung bis zum Ende der Einwirkung der Zusatzmagnetfelder akkumuliert und T die Dauer des längsten der $N$ HF-Pulse. $M_{xy}$ und $B_{1,n}$ sind komplexe Größen, deren Real- und Imaginärteil die x- bzw. y- Komponente der jeweiligen Vektorgröße in dem mit der HF rotierenden Koordinatensystem beschreibt (vektorielle Größen sind fettgedruckt).

In den Berechnungsverfahren von Pauly et al. und Katscher et al. wird neben dem anzuregenden Zielmuster $M_{xy}$ eine k-Raum-Trajektorie $\mathbf{k}^{nom}(t)$, die im k-Raum-Formalismus mit $\varphi(\mathbf{x},t)=\mathbf{x}k(t)$ die zeitliche, ortsabhängige Entwicklung der Phase der Transversalmagnetsierung, im Folgenden kurz als (lokale) Phasenentwicklung bezeichnet, festlegt, vorgegeben und in Gleichung (1) eingesetzt. Die lokale Phasenentwicklung beschreibt dabei die Änderung der Transversalmagnetisierungsphase aufgrund der zur k-Raum-Trajektorien-Erzeugung verwendeten Gradientenfelder. Damit liefert die Lösung des inversen Problems zu Gleichung (1) die gewünschten HF-Pulse $B_{1,n}(t)$, die bei Applikation während des exakten Durchlaufens der vorgegebenen k-Raum-Trajektorie die gewünschte Verteilung der Transversalmagnetisierung erzeugen.

Im Allgemeinen erreichen so berechnete HF-Pulse eine hohe Realisierungstreue der gewünschten Transversalmagnetisierungsverteilung nur für kleine Auslenkungswinkel der Magnetisierung im Gültigkeitsbereich der Kleinwinkeinäherung, weshalb sie auch als Kleinwinkel-Pulse oder small-tip-angle-pulses bezeichnet werden. Soll auf die Kleinwinkelnäherung verzichtet und auch HF-Pulse für große Auslenkungswinkel (Großwinkelpulse, large-tip-angle-pulses) berechnet werden, ergibt sich aus den Blochgleichungen ein nichtlineares Gleichungssystem, für das bisher keine analytischen Lösungen bekannt sind. Zur Bestimmung von HF-Pulsen, die beispielsweise als Inversionspulse oder Refokussierungspulse geeignet sind, muss daher auf andere Näherungen oder iterative Lösungen des Gleichungssystems zurückgegriffen werden, wie es beispielsweise von Xu et al. [7] vorgeschlagen wird. In diesem Beispiel wird von einem linearen Zusammenhang zwischen dem Sendefeld ($B_1$) und dem damit erreichten Anregungswinkel ausgegangen. Wie im Falle der Kleinwinkelnäherung geht auch hier, wie in den meisten Berechnungsverfahren, eine Phasenentwicklung $\varphi(\mathbf{x},t)$ der Transversalmagnetisierung in die Berechnung der HF-Pulse ein. Diese Phasenentwicklung wird hier im Speziellen durch eine k-Raum-Trajektorie mit $\varphi(\mathbf{x},t)=\mathbf{x}k(t)$ definiert.

Da die Berechnungen der HF-Pulse in den bisher vorgestellten Verfahren alle auf Basis einer k-Raum-Trajektorie erfolgen, ist für eine hohe Realisierungstreue der gewünschten Transversalmagnetisierungsverteilung diesbezüglich eine Übereinstimmung zwischen den Annahmen im Berechnungsschritt und den Gegebenheiten im Experiment essentiell: HF-Pulse können von modernen MR-Geräten im Allgemeinen mit hoher Genauigkeit bezüglich Amplitude und Phase appliziert werden. Die k-Raum-Trajektorie kann jedoch, wie im Folgenden dargestellt, deutliche Abweichungen von ihrem nominell angenommen Verlauf aufweisen, wodurch die Realisierungstreue der Transversalmagnetisierungsverteilung abhängig von der Stärke der Abweichungen und der Wahl der k-Raum-Trajektorie deutlich verringert werden kann und Artefakte auftreten können.

Ein Durchlaufen der k-Raum-Trajektorie wird in der Regel durch die Applikation von Gradientenpulsen mit im Raum linearen, dem Grundfeld des Magnetresonanzmesssystems überlagerten Zusatzmagnetfeldern realisiert. Neben diesen beabsichtigten Zusatzmagnetfeldern treten im Experiment jedoch auch unbeabsichtigte Zusatzmagnetfelder auf, die weder räumlich linear noch zeitlich konstant sein müssen. Als solche unbeabsichtigte Zusatzmagnetfelder lassen sich alle Abweichungen von den beabsichtigten Feldern zusammenfassen. Unter anderem sind dies Inhomogenitäten und zeitliche Variationen des als homogen und statisch angenommenen magnetischen Grundfeldes, welche dafür sorgen, dass die Resonanzfrequenz der Kernspins an bestimmten Orten des Untersuchungsobjektes oder zu bestimmten Zeiten nicht mehr mit der eingestrahlten HF-Frequenz übereinstimmt, also Offresonanzen auftreten. Weiterhin sind Amplitudenabweichungen und zeitlicher Versatz real applizierter Gradientenpulse im Vergleich zu ihren nominell vorgegebenen Werten aufgrund von technischen Imperfektionen des Gradientensystems und aufgrund von physikalisch technischen Störeinflüssen, wie z. B. induzierten Wirbelströmen und Kopplungen in und zwischen den Komponenten des Magnetresonanzmesssystems zu nennen. Wird im Folgenden von beabsichtigten oder unbeabsichtigten Zusatzmagnetfeldern gesprochen, seien auch solche Fälle eingeschlossen, in denen die Feldstärke dieser Zusatzmagnetfelder Null beträgt.

Die zeitliche Entwicklung der Transversalmagnetisierungsphase (Phasenentwicklung $\varphi(x,t)$) wird im Experiment somit nicht mehr allein durch eine vorgegebene nominelle k-Raum-Trajektorie bzw. die zu deren Erzeugung verwendeten beabsichtigten Zusatzmagnetfelder festgelegt, sondern außerdem durch die genannten unbeabsichtigten Magnetfelder.

Als Folge dieser Störeinflüsse sind nach und nach weitere Ansätze zur Pulsberechnung für räumlich selektive Anregung entstanden.

So werden in einer Arbeit von Oelhafen et al. [16] in einer Vorbereitungsmessung Kalibrationsparameter zur Skalierung und zeitlichen Verschiebung von Gradienten- und HF-Pulsen bestimmt. Auf diese Weise lassen sich Abweichungen von einer nominellen k-Raum-Trajektorie kompensieren, sofern räumlich nicht-lineare Zusatzmagnetfelder vernachlässigbar sind. Dieser Ansatz eignet sich jedoch nur für den speziellen Fall so genannter Echo-Planar-Pulse.

In anderen Arbeiten [5, 6] wurde der sog., conjugate-phase (CP)-Ansatz aus der Bildrekonstruktion herangezogen, welcher in der Lage ist, zumindest Effekte von Offresonanzen, die meist in einem Vorexperiment ermittelt werden müssen, als eine Komponente der unbeabsichtigten Zusatzmagnetfelder zu berücksichtigen und in gewissem Maße zu korrigieren. Trotzdem sind diese Ansätze zur Pulsberechnung in mehrerlei Hinsicht nicht optimal. Im Allgemeinen bringen die Algorithmen Pulse hervor, die hinsichtlich der Realisierungstreue der gewünschten Transversalmagnetisierungsverteilung suboptimal sind, insbesondere dann, wenn die k-Raum-Trajektorie ein gewisses Undersampling aufweist oder wenn die Offresonanz-Einflüsse räumlich stark variieren. Eine neuere Methode zur Pulsberechnung, welche von Yip et al. [8] eingeführt und von Grissom et al. [9] für den Mehrkanal-Sendefall verallgemeinert wurde, beruht auf einem Optimierungsansatz und erzielt in zweifacher Hinsicht Verbesserungen bei der Anregungsgenauigkeit. Zum Einen ist sie robuster gegenüber Undersampling Im k-Raum, zum Anderen kann sie Offresonanz-Einflüsse auf einfachere Weise bei der Pulsberechnung berücksichtigen. Außerdem bietet sie die Möglichkeit, weitere Randbedingungen, wie die Kontrolle der integrierten oder auch der maximalen HF-Sendeleistung, in die Berechnung mit einfließen zu lassen, was im Hinblick auf die SAR-Kontrolle (SAR: Specific Absorption Rate, spezifische Absorptionsrate) oder auf technische Beschränkungen bei den HF-Leistungssendern von Bedeutung ist. Abweichungen der real durch das Gradientensystem erzeugten k-Raum-Trajektorie von der theoretisch vorgegebenen können jedoch auch mit diesen Methoden nicht berücksichtigt werden.

Ein Ansatz zur Lösung letzteren Problems ist, wie von Takahashi et al. für den Einkanal-Sendefall [17] oder von Ullmann et al. [10] für den Mehrkanal-Sendefall beschrieben, die tatsächlich erzeugte k-Raum-Trajektorie in einem Vorexperiment in situ zu messen und die Pulsberechnung anschließend auf Basis der experimentell ermittelten k-Raum-Trajektorie durchzuführen. Somit sind die berechneten HF-Pulse bereits an Abweichungen von der nominellen k-Raum-Trajektorie angepasst und sie können diese in gewissem Maße kompensieren. Nach Ullmann et al. [10] erfolgt die Ermittlung der tatsächlich durchlaufenen k-Raum-Trajektorie bzw. der tatsächlich wirkenden Gradientenpulse mittels einer der äquivalenten Methoden von Duyn et al. [11] oder Zhang et al [15] sukzessive getrennt für jeden Gradientenkanal (Einzelkanalmessung). Dazu wird der zu vermessende Gradientenpuls eines einzelnen Gradientenkanals appliziert, während simultan MR-Signal aus einer Schicht, die senkrecht zu der jeweiligen Feldgradientenrichtung im Abstand d vom Gradientensystemzentrum liegt, aufgezeichnet wird. Anschließend wird das Experiment für eine zweite Schicht im Abstand -d, also auf der gegenüberliegenden Seite des Gradientensystemzentrums wiederholt, was insgesamt als Zweischichtmessung bezeichnet wird. Die Einzelkanalmessung ist dabei notwendig, da die gleichzeitige Applikation von Gradientenpulsen mit mehreren Gradientenkanälen und mit Feldgradientenkomponenten parallel zu der angeregten Schicht zu folgenden Problemen führen kann: Zum einen würde die Wirkung eines Gradientenkanals auf eine bestimmte Fortbewegungsrichtung im k-Raum und damit die Separation der einzelnen k-Raum-Richtungen verhindert oder deutlich erschwert werden. Zum anderen würde eine zusätzliche, räumlich und zeitlich variierenden Phase der Transversalmagnetisierung auftreten, was die spätere phasensensitive Auswertung verfälschen oder durch Dephasierung der Magnetisierung und dadurch verursachtem Signalverlust unmöglich machen würde. Die Zweischichtmessung wird anschließend für alle Gradientenkanäle wiederholt. Aus der unter Einwirkung der Gradientenpulse vollzogenene Phasenentwicklung der aufgezeichneten MR-Signale kann anschließend mit der Kenntnis der einzelnen Schichtpositionen die k-Raum-Trajektorie berechnet werden. Ein großer Nachteil dieser Methode ist jedoch, dass, aufgrund der Einzelkanalmessungen, Kopplungen der einzelnen Gradientenspulen, wie sie bei simultanem Betrieb aller Gradientenkanäle auftreten können, nicht vollständig detektiert werden können. Ein weiterer Nachteil ist, dass Einflüsse oben angesprochener, unbeabsichtigter nichtlinearer Zusatzmagnetfelder mittels der Zweischichtmessung entweder nicht detektiert oder nicht separiert werden können und dann fälschlicherweise als Einflüsse von linearen Feldern interpretiert werden.

Dies ist ein zentrales Problem der bisher beschriebenen Verfahren. Die genannten Methoden können Komponenten von Zusatzmagnetfeldem, deren räumlicher Verlauf höhere als lineare Ordnungen enthält, weder rekonstruieren noch könnten solche Informationen in den auf k-Raum-Trajektorien basierten Methoden zur Pulsberechnung berücksichtigt werden. Denn der k-Raum-Formalismus geht vielmehr von Zusatzmagnetfeldern aus, die einen linearen räumlichen Verlauf, d. h. einen in einer Raumrichtung konstanten Feldgradienten, aufweisen und damit einen ebenfalls in dieser Raumrichtung konstanten Phasengradienten der Transversalmagnetisierung und somit eine für das ganze Objekt global gültige k-Raum-Trajektorie erzeugen. Diese Bedingung wird von im Raum nichtlinearen Magnetfeldern nicht erfüllt, weshalb solche Magnetfelder, beabsichtigte und unbeabsichtigte, nicht in Form einer k-Raum-Trajektorie beschrieben und in die bisherigen Pulsberechnungsmethoden integriert werden können. Es sei darauf hingewiesen, dass nichtlineare Zusatzmagnetfelder nicht nur als unbeabsichtigte Komponenten auftreten können, sondern diese auch beabsichtigt sein können und beispielsweise im Rahmen kürzlich vorgestellter, neuartiger Gradientenkonzepte [12] angewandt werden. Solche nichtlinearen beabsichtigten Felder können zum Teil bisher übliche, lineare Gradientenfelder ersetzen, womit im Falle der selektiven Anregung anstelle der k-Raum-Trajektorie eine beabsichtigte, zeitliche ortsabhängige Phasenentwicklung der Transversalmagnetisierung vorgegeben werden kann.

Die bisher vorgestellten Methoden zur Bestimmung und zur Berücksichtigung in der HF-Puls-Berechnung von experimentellen Imperfektionen, die sich in Form unbeabsichtigter Zusatzmagnetfelder äußern, sind daher ungeeignet, insbesondere dann, wenn die zu kompensierenden unbeabsichtigten Zusatzmagnetfelder nichtlinear im Raum sind, oder wenn bereits beabsichtigte Zusatzmagnetfelder mit nichtlinearem Verlauf vorgegeben werden.

Aufgabe der Erfindung

Es ist daher Aufgabe der vorliegenden Erfindung, ein Verfahren zur Gewinnung von Amplituden- und Phasenverläufen von HF-Pulsen für die ein- oder mehrkanalige selektive Anregung in einem sog. Hauptexperiment anzugeben, bei welchem gleichzeitig mit den HF-Pulsen applizierte, beabsichtigte und/oder unbeabsichtigte Zusatzmagnetfelder räumliche Verläufe mit nichtlineare Komponenten und/oder zeitlich nichtkonstante Verläufe aufweisen.

Diese Aufgabe wird durch ein Verfahren gemäß Patentanspruch 1 gelöst. Weitere Varianten sowie weitere vorteilhafte Eigenschaften und Ausgestaltungen sind in den Unteransprüchen beschrieben.

Kurze Beschreibung der Erfindung

Bei dem erfindungsgemäßen Verfahren wird bei der Vorbereitungsmessung die zeitliche Änderung der Transversalmagnetisierungsphase im Objekt unter Einwirkung der Zusatzmagnetfelder, welche beim Hauptexperiment während der selektiven Anregung zur Anwendung kommen, ortsaufgelöst gemessen. Die Amplituden- und Phasenverläufe der Hochfrequenzpulse für das Hauptexperiment werden direkt, d.h. ohne die Berechnung einer für das ganze Objekt global gültigen k-Raum-Trajektorie, auf Basis dieser ortsaufgelöst gemessenen zeitlichen Änderung der Transversalmagnetisierungsphase berechnet.

Zur Durchführung des Hauptexperiments werden dann HF-Pulse mit den so ermittelten Amplituden- und Phasenverläufen in das zu untersuchende Objekt eingestrahlt. Der räumliche und zeitliche Verlauf der Zusatzmagnetfelder, die während der selektiven Anregung zur Anwendung kommen, soll während der Vorbereitungsmessung und dem Hauptexperiment im Wesentlichen identisch sein. Dies bedeutet, dass zumindest die kontrollierbaren Zusatzmagnetfelder im Vorbereitungsexperiment und im Hauptexperiment gleich gewählt werden. Die berechneten Pulse sind somit an die beim Hauptexperiment auftretenden Magnetfelder angepasst. Kleine Abweichungen können auftreten und müssen im Rahmen der technisch und experimentell möglichen Reproduzierbarkeit hingenommen werden.

Die Zusatzmagnetfelder können aus beabsichtigten und unbeabsichtigten Komponenten bestehen, wobei nicht immer beide Komponenten vorhanden sein müssen.

Das erfindungsgemäße Verfahren ist besonders vorteilhaft, wenn es zur mindestens partiellen Kompensation von Effekten von unbeabsichtigten Komponenten der Zusatzmagnetfelder, auf die im Hauptexperiment erzeugte Transversalmagnetisierungsverteilung verwendet wird. Derartige unbeabsichtigte Komponenten können bspw. aus Grundfeldinhomogenitäten, Wirbelstromeffekten, Suszeptibilitätseffekten und Imperfektionen des Gradientensystems resultieren.

In einer Variante des erfindungsgemäßen Verfahrens weisen die beabsichtigten Komponenten der Zusatzmagnetfelder räumlich konstante Gradienten innerhalb des Objektes auf und der zeitliche Verlauf der Gradientenstärke lässt sich durch eine k-Raum-Trajektorie beschreiben.

Besonders vorteilhaft ist das Verfahren jedoch, wenn die beabsichtigten Komponenten der Zusatzmagnetfelder räumlich nichtkonstante Gradienten innerhalb des Objektes aufweisen und der zeitliche und räumliche Verlauf der Gradientenstärke durch eine zeitliche Änderung der Transversalmagnetisierungsphase beschreibbar ist. Hierdurch können gegenüber herkömmlichen Gradientenfeldern neue Kodierungsmöglichkeiten, schnellere Schaltzeiten und/oder stärkere lokale Gradienten zum Einsatz kommen.

Bei der Berechnung der Amplituden- und Phasenverläufe der Hochfrequenzpulse kann eine Kleinwinkelnäherung angewendet wird. Dies resultiert dann jedoch auch in HF-Pulsen, die nur für kleine Auslenkungswinkel geeignet sind.

Alternativ hierzu kann bei der Berechnung der Amplituden- und Phasenverläufe der Hochfrequenzpulse keine Kleinwinkelnäherung angewendet werden. Zur Berechnung von sog. Großwinkelpulsen müssen andere Näherungsverfahren als bei der Kleinwinkelnäherung oder iterative Lösungsansätze verwendet werden.

Besonders vorteilhaft ist das erfindungsgemäße Verfahren, wenn das Objekt mindestens zwei Kernspinensembles mit voneinander verschiedenen Präzessionsfrequenzen enthält, wobei jedes Kernspinensemble einen Beitrag zur Transversalmagnetisierung leistet, und wenn für mindestens einen dieser Beiträge eine zu erzeugende n-dimensionale räumliche Verteilung (n>=1) vorgegeben wird. Die n-dimensionalen räumlichen Verteilungen der einzelnen Beiträge zur Transversalmagnetisierung können gleich oder voneinander verschieden sein und bilden zusammen die n-dimensionale räumliche Verteilung der Transversalmagnetisierung im Objekt.

Bei einer Variante wird in der Vorbereitungsmessung die Phasenentwicklung der Transversalmagnetisierung von nur einer spektralen Komponenten des Objektes gemessen, wobei die Bandbreite des dabei zur Anregung verwendeten HF-Pulses im Frequenzraum so gewählt werden sollte, dass nur eine spektrale Komponente des Objektes zum MR-Signal beiträgt. Mit dem erfindungsgemäßen Verfahren können somit auch HF-Pulse für eine räumlich spektral selektive Anregung ermittelt werden.

Besonders vorteilhaft ist es, wenn Amplituden- und Phasenverläufe von aufeinander abgestimmten Hochfrequenzpulsen berechnet werden, die beim Hauptexperiment zur Erzeugung der vorgegebenen Transversalmagnetisierungsverteilung parallel von verschiedenen Hochfrequenz-Sendeantennen in das Objekt eingestrahlt werden. Hierdurch kann unter anderen Vorteilen eine Verkürzung der Dauer der Hochfrequenzpulse und damit die Wirkungsdauer unerwünschter Störeffekte und/oder eine Steigerung der Anregungsgenauigkeit und/oder eine Reduktion der spezifischen Absorptionsrate erreicht werden.

Bei einer speziellen Variante kann die Messzeit der Vorbereitungsmessung verkürzt und/oder deren Genauigkeit erhöht werden, indem bei der Vorbereitungsmessung mehr als eine Empfangsantenne verwendet wird.

Vorteilhaft ist auch eine Variante, bei der im Zuge der Vorbereitungsmessung auch die Entwicklung der Amplitude der Transversalmagnetisierung ortsaufgelöst gemessen wird und aus der ortsaufgelöst gemessenen Entwicklung der Amplitude eine oder mehrere Zeitkonstanten der transversalen Relaxation der Magnetisierung des Objekts ermittelt werden. Diese Zeitkonstanten können beispielsweise bei der nachfolgenden Pulsberechnung berücksichtigt werden, wodurch Relaxationseffekte, die während des Hauptexperimentes auftreten kompensiert werden können.

Detaillierte Beschreibung der Erfindung und Zeichnung

Die Gewinnung der Amplituden und Phasenverläufe der HF-Pulse gemäß dem erfindungsgemäßen Verfahren erfolgt in mehreren Teilschritten.

Im ersten Teilschritt werden zunächst dem Problem angepasste, beabsichtigte Zusatzmagnetfelder gewählt, die während der zur selektiven Anregung applizierten HF-Pulse eine Sendeortskodierung ermöglichen.

Diese beabsichtigten Zusatzmagnetfelder können in einer Variante des erfindungsgemäßen Verfahrens so beschaffen sein, dass sie, wie von herkömmlichen Gradientensystemen erzeugt, einen linearen räumlichen Verlauf aufweisen, und durch eine k-Raum-Trajektorie beschrieben werden können. Die Trajektorie muss den k-Raum dabei in allen Dimensionen, in welchen eine räumliche Modulation der Transversalmagnetisierung vorgenommen werden soll, in ausreichender Dichte und Ausdehnung abtasten, um ein Anregungsgebiet mit gewünschter Ausdehnung und Auflösung zu erfassen. Im Rahmen einer Mehrkanalanregung kann dabei ein gewisser Grad an Undersampling zulässig sein, der durch die Anzahl der Antennenarrayelemente und die Beschaffenheit deren räumlicher Sendeprofile nach oben begrenzt wird.

In einer anderen Variante weisen die beabsichtigten Zusatzmagnetfelder dagegen einen nichtlinearen räumlichen Verlauf auf. Auch diese Felder müssen dem Problem angepasst gewählt werden, so dass durch sie eine zur selektiven Anregung geeignete Phasenentwicklung der Transversalmagnetisierung erzeugt wird. Gegenüber herkömmlichen Gradientensystemen lassen sich so neue Kodierungsmöglichkeiten, schnellere Schaltzeiten und/oder stärkere lokale Gradienten ermöglichen. Wie bereits beschrieben, ist der klassische k-Raum-Formalismus in solchen Fällen nicht mehr anwendbar. Das erfindungsgemäße Verfahren ist daher unter solchen Umständen besonders vorteilhaft.

In einem zweiten Schritt müssen während einer Vorbereitungsmessung in situ alle Beiträge zur Phasenentwicklung der Transversalmagnetisierung ortsaufgelöst bestimmt werden. Diese Vorbereitungsmessung umfasst eine MR-Messung.

Es wird dabei nicht mehr davon ausgegangen, dass die Phase der Transversalmagnetisierung nur durch beabsichtigte Zusatzmagnetfelder vorgegeben wird, sondern zusätzlich durch weitere Terme, resultierend aus unbeabsichtigten Zusatzmagnetfeldern. Für den Fall linearer beabsichtigter Felder und einer vorgegebenen, nominellen k-Raum-Trajektorie können zur Phasenentwicklung der Transversalmagnetsierung beispielsweise folgende Terme beitragen:

$$\varphi(\mathbf{x},t) = \sum_i x_i [k_i^{nom}(t+\tau_i) + \Delta k_i(t)] + \varphi_{\Delta G}(\mathbf{x},t) + \varphi_{\Delta BO}(\mathbf{x},t)$$

Dabei steht die Summationsvariable i für die drei Raumrichtungen (x, y, z), $\tau$ stellt eine zeitliche Verschiebung der über den jeweiligen Gradientenkanal applizierten Gradientenpulse dar, $\Delta k_j$ ist eine Abweichung von der nominellen k-Raum-Trajektorie aufgrund einer räumlich linearen, separierbare Abweichung der Gradientenfeldamplitude, $\varphi_{\Delta G}$ beschreibt Phasenbeiträge aus nicht linear separierbaren Abweichungen der Gradientenfeldamplituden und $\varphi_{\Delta B0}$ solche aus lokalen Grundfeldinhomogenitäten.

Das Ergebnis dieser Vorbereitungsmessung ist ein Datensatz der ortsaufgelöst gemessenen Phasenentwick-

lung der Transversalmagnetsierung φ(**x**,t), die die Gesamtheit aller Effekte beabsichtigter und unbeabsichtigter Zusatzmagnetfelder enthält. Zu deren Messung kann beispielsweise eine Methode von Papadakis et al. [13] zur Anwendung kommen.

Eine Optimierung dieser Vorbereitungsmessung bezüglich der für die Datenaufnahme notwendigen Messzeit kann erfolgen, indem für den Empfang mehr als eine Empfangsantenne verwendet wird. Hierbei ist es oftmals möglich, die zum parallelen Senden verwendeten Sendeantennen auch für den Empfangsfall als Empfangsantennen zu nutzen. Aufnahme- und Rekonstruktionstechniken aus der parallelen Bildgebung ermöglichen so eine zeitsparende Reduktion der notwendigen Ortskodierungsschritte mit Gradientenpulsen und deren partielle Ersetzung durch eine Sensitivitätskodierung.

Im dritten Schritt erfolgt schließlich die Berechnung der Amplituden- und Phasenverläufe der zur Kompensation der unerwünschten Zusatzmagnetfelder und zur selektiven Anregung geeigneten HF-Pulse auf Basis der in der Vorbereitungsmessung ortsaufgelöst ermittelten Phasenentwicklung.

Die Berechnung kann ausgehend von Gleichung (1) erfolgen, die beispielsweise mittels einer Erweiterung bzw. Verallgemeinerung des Verfahrens von Grissom gelöst bzw. approximiert werden kann, wie es im Folgenden gezeigt wird:

Gleichung (1) legt in der Kleinwinkelnäherung die Verteilung der Transversalmagnetisierung fest. Abweichend von bisher üblichen Berechnungsverfahren wird im erfindungsgemäßen Verfahren der Phasenterm φ(**x**,t) in seiner Allgemeinheit beibehalten, ohne ihn über eine k-Raum-Trajektorie zu definieren und ohne ihn damit auf im k-Raum-Formalismus beschreibbare Effekte linearer Zusatzmagnetfelder einzuschränken. Vielmehr werden für die Größe φ(**x**,t) die in der Vorbereitungsmessung ermittelten Werte direkt verwendet.

Anschließend kann die Ermittlung der HF-Pulse $B_{1,n}(t)$ (n=1...N) für die N-kanalige selektive Anregung einer vorgegebenen Transversalmagnetisierungsverteilung M(x) analog zur Methode von Grissom et al. unter Verwendung der Kleinwinkelnäherung erfolgen:

Gleichung (1) lässt sich in Raum (Index u) und Zeit (Index v) diskretisieren und als Matrixgleichung ausdrücken:

$$\mathbf{M} = \mathbf{AB}$$

mit

$$M_u = M(\mathbf{x}_u); \qquad B_{n,v} = B_{1,n}(t_v); \qquad A_{u,(n,v)} = i\gamma M_0 S_n(\mathbf{x}_u) e^{i\varphi(x_u,t_v)} \Delta t \tag{2}$$

Dabei wird für $M_u$ eine im Raum gewünschte anzuregende Verteilung der Transversalmagnetisierung vorgegeben, für $S_n(x_u)$ werden gemessene oder berechnete Sendeprofile der zur Anregung verwendeten Antennenarrayelemente eingesetzt und für $\varphi(x_u,t_v)$ werden die in der Vorbereitungsmessung ermittelten Daten der lokalen Phasenentwicklung verwendet. Durch Lösung bzw. Approximation von Gleichung (2), beispielsweise mittels eines Minimierungsansatzes mit Tikhonov-Regularisierung (vgl. [9]), lassen sich schließlich an die tatsächlich durchlaufene Phasenentwicklung optimal angepasste HF-Pulse $B_{1,n}(t_v)$ berechnen.

Die Berechnung der HF-Pulse erfolgt in der Annahme, dass während der späteren Applikation der HF-Pulse bezüglich der Zusatzmagnetfelder im Rahmen der experimentellen Reproduzierbarkeit identische Verhältnisse vorliegen, wie sie in der Vorbereitungsmessung durch die zu vermessenden Zusatzmagnetfelder erzeugt worden sind. Da davon im Wesentlichen ausgegangen werden kann, sind die berechneten Pulse an die auftretenden Magnetfelder angepasst, sodass die gewünschte Transversalmagnetisierungsverteilung trotz eventuell beim Hauptexperiment vorliegender experimenteller Imperfektionen sehr genau erreicht werden kann.

Das geschilderte Berechnungsverfahren ist sowohl für die Ermittlung von HF-Pulsen für die einkanalige Anregung als auch von solchen für die mehrkanalige, parallele Anregung anwendbar. Gleichung (1) enthält für letzteren Fall bereits die Summation über *N* Sendeantennen womit nach Einsetzen der Sendeprofile *N* aufeinander abgestimmte HF-Pulse berechnet werden können, die während der selektiven Anregung parallel von verschiedenen Sendeantennen eines Sendeantennenarrays mit ihren individuellen Sendeprofilen in ein Objekt eingestrahlt werden. Die dabei durch die räumliche Variation der Sendeprofile zusätzlich hinzugekommenen Möglichkeiten der Sendeortskodierung bzw. Freiheitsgrade lassen sich bereits in der Berechnung der HF-Pulse derart vorteilhaft nutzen, dass die resultierenden HF-Pulse bezüglich mehrerer Kriterien optimiert werden. Unter anderem sind eine verkürzte Dauer der HF-Pulse mit beispielsweise reduzierter Wirkungszeit von Offresonanzeffekten und daraus resultierender genauerer selektiver Anregung genauso möglich wie eine exaktere Approximation der gewünschten Transversalmagnetisierungsverteilung oder eine Reduktionen der spezifischen Absorptionsrate.

Das erfindungsgemäße Verfahren ist auch für die Anwendung der räumlich spektral selektiven Anregung von Objekten geeignet, die mehrere Kernspinensembles mit voneinander verschiedenen Präzessionsfrequenzen enthalten. In einem solchen Falle sollte in der Vorbereitungsmessung die Phasenentwicklung der Transversalmagnetisierung von nur einer spektralen Komponente des Objektes gemessen werden. Dies lässt sich beispielsweise durch die Anregung nur einer spektralen Komponente mit einem HF-Puls mit geringer Bandbreite im Frequenzraum erreichen. Die so gewonnenen Daten lassen sich dann analog zu der bisherigen Beschreibung auch in den Berechnungsverfahren von räumlich spektral selektiven Pulsen (beispielsweise nach [4]) als ortsabhängige Phasenentwicklung $\varphi(\mathbf{x},t)$ verwenden.

Auch wenn die Berechnung der HF-Pulse hier beispielhaft anhand der Berechnung von Kleinwinkelpulsen dargestellt wurde, ist das erfindungsgemäße Verfahren auch zur Berechnung von Großwinkelpulsen verwendbar, sofern die jeweiligen Berechnungsverfahren ebenfalls auf der Vorgabe einer lokalen Phasenentwicklung der Transversalmagnetisierung $\varphi(\mathbf{x},t)$ beruhen, für die dann analog die in der Vorbereitungsmessung ermittelten Werte verwendet werden. Als Beispiel für eine Berechnung von Großwinkelpulsen, sei auf das bereits genannte Verfahren von Xu et al. [7] verwiesen, in dem, wie in die meisten Berechnungsverfahren, die Phasenentwicklung der Transversalmagnetisierung eingeht und diese mittels einer k-Raum-Trajektorie beschrieben wird $\varphi(\mathbf{x},t)=\mathbf{x}\mathbf{k}(t)$. Dieser Ausdruck lässt sich, dem erfindungsgemäßen Verfahren folgend, durch die in der Vorbereitungsmessung ermittelten Phasenentwicklung ersetzen und somit auch die Berechnung von Großwinkelpulsen optimal an unbeabsichtigte Zusatzmagnetfelder anpassen.

Besonders vorteilhaft ist eine Variante des Verfahrens, in der im Zuge der Vorbereitungsmessung auch Zeitkonstanten der transversalen Relaxation bestimmt werden. Dazu wird aus dem Verlauf des MR-Signals der Vorbereitungsmessung nicht nur die lokale Phasenentwicklung der Transversalmagnetisierung, sondern auch die lokale Entwicklung ihrer Amplitude ermittelt. Aus dieser Information, die bei Bedarf auch aus Datenpunkten, die vor dem Beginn oder nach dem Ende der in der Vorbereitungsmessung applizierten kontrollierbaren Zusatzmagnetfelder liegen, gewonnen werden kann, lassen sich ortsaufgelöst Zeitkonstanten der üblicherweise mit Hilfe eines exponentiellen Verlaufes modellierten transversalen Relaxation der Magnetisierung bestimmen. Diese Zeitkonstanten, zu deren Ermittlung in diesem Fall kein zusätzliches Messexperiment nötig ist, können anschließend beispielsweise für verschiedene Korrektur- und Optimierungsverfahren verwendet werden. Ein Beispiel hierfür ist die Verwendung der Zeitkonstanten in Kombination mit dem Verfahren von Haas et al. [14] , mit dem Relaxationseffekte, die während der Applikation der selektiven HF-Pulse auftreten, ebenfalls in die Berechnung der HF-Pulse mit einbezogen und mindestens teilweise kompensiert werden. Dazu wird in die zu Gleichung (1) führenden Blochgleichungen die bisher vernachlässigte Relaxation explizit durch einen Exponentialterm, der die Zeitkonstanten der transversalen Relaxation enthält, integriert und entsprechend auch in den HF-Puls-Berechnungsverfahren berücksichtigt.

Das erfindungsgemäße Verfahren bietet den großen Vorteil, dass im Gegensatz zu bisher verwendeten Methoden eine einzelne Vorbereitungsmessung ausreicht, um alle relevanten Beiträge bezüglich der Transversalmagnetisierungsphase zu bestimmen. Es entfällt daher eine Kombination von Ergebnissen aus verschiedenen Messungen, was die Gefahr zusätzlicher Fehler und Ungenauigkeiten mit sich bringen würde. Außerdem ist es mit diesem Verfahren möglich, die endgültig verwendeten Gradientenpulse bereits während der Vorbereitungsmessung zu applizieren, ohne auf die getrennte und aufeinanderfolgende Aktivierung einzelner Gradientenkanäle beschränkt zu sein. Die Einflüsse der Zusatzmagnetfelder beliebiger räumlicher Verläufe auf die Phasenentwicklung der Transversalmagnetisierung lassen sich somit in ihrer Gesamtheit erfassen. Anschließend lassen sich diese Informationen vollständig in die HF-Pulsberechnung integrieren und zur Kompensation unbeabsichtigter Zusatzmagnetfelder nutzen.

Die ermittelten HF-Pulse können schließlich im Hauptexperiment zur selektiven Anregung eines Objektes zusammen mit den Zusatzmagnetfeldern appliziert werden.

Das folgende Ausführungsbeispiel soll die Erfindung unter Bezugnahme auf die beigefügten Abbildungen näher erläutern. Bei dem Ausführungsbeispiel handelt es sich um die Bestimmung eines zweidimensional räumlich selektiven Anregungspulses unter Verwendung des erfindungsgemäßen Verfahrens zur Kompensation experimenteller Imperfektionen mit anschließender schichtselektiver 2D-MRI-Aufnahme. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1      eine schematische Darstellung eines zur Durchführung des erfindungsgemäßen Verfahrens geeigneten MRI-Systems nach dem Stand der Technik;

Fig. 2      eine schematische Darstellung eines zur Durchführung des erfindungsgemäßen Verfahrens geeigneten HF-Sendeantennenarrays nach dem Stand der Technik;

Fig. 3    ein Flussdiagramm eines möglichen Ablaufs von Vorbereitungsmessung, Berechnungsschritt und selektiver Anregung;

Fig. 4a    eine mögliche Zielverteilung der Transversalmagnetisierung;

Fig. 4b    eine für die Zielverteilung aus Fig. 4a geeignete, während des HF-Pulses näherungsweise zu durchlaufende, nominelle k-Raum-Trajektorie;

Fig. 5    eine schematische Darstellung zur Abfolge von Gradienten und HF-Pulsen während der Vorbereitungsmessung zur Bestimmung der lokalen Phasenentwicklung der Transversalmagnetisierung;

Fig. 6    eine Darstellung der bei exakter Applikation der nominellen k-Raum-Trajektorie erwarteten Phasenentwicklung der Transversalmagnetisierung (gestrichelte Linien) sowie der in der Vorbereitungsmessung tatsächlich gemessenen Phasenentwicklung (durchgezogenen Linien) an den x-y-Koordinaten (1mm/0mm) und (1mm/1mm) mit dem Nullpunkt im Gradientenzentrum;

Fig. 7    den Amplituden- und Phasenverlauf des HF-Pulses, der zur selektiven Anregung dem ersten Sendekanal zugewiesen wird und der entsprechend dem erfindungsgemäßen Verfahren auf Basis der Daten der Vorbereitungsmessung berechnet wurde;

Fig. 8a    ein MR-Bild einer als anzuregendes Objekt verwendeten, wassergefüllten Kunststoffkugel überlagert mit der angestrebten Zielverteilung der Transversalmagnetisierung;

Fig. 8b    im Hauptexperiment erhaltene Verteilung der Transversalmagnetisierung im Objekt bei Applikation von HF-Pulsen, deren Berechnung auf Basis der nominellen k-Raum-Trajektorie erfolgte; und

Fig. 8c    im Hauptexperiment erhaltene Verteilung der Transversalmagnetisierung im Objekt bei Applikation von HF-Pulsen, deren Berechnung entsprechend des erfindungsgemäßen Verfahrens auf Basis der in der Vorbereitungsmessung ermittelten Phasenentwicklung erfolgte.

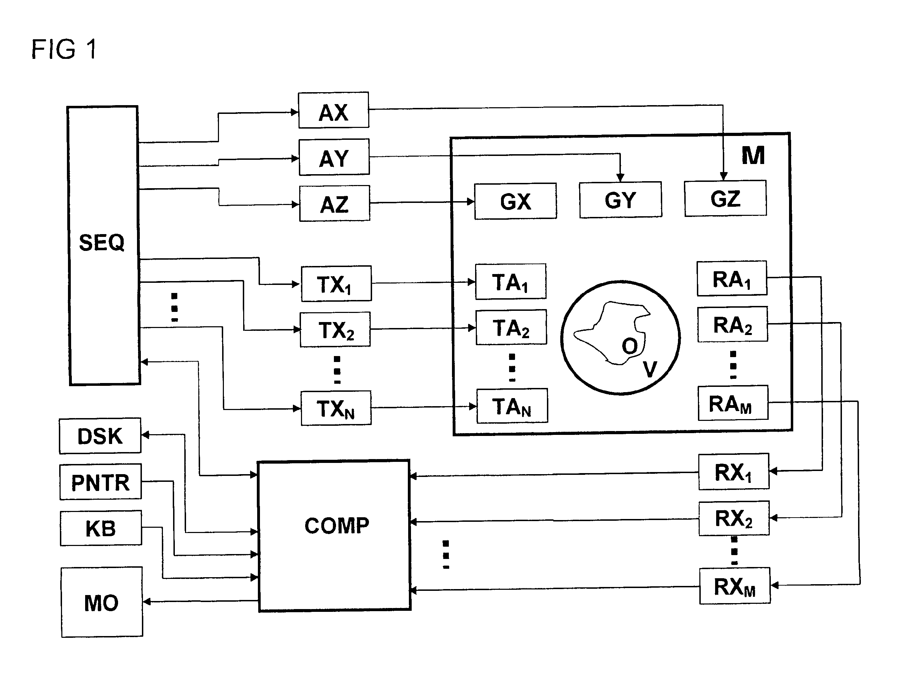

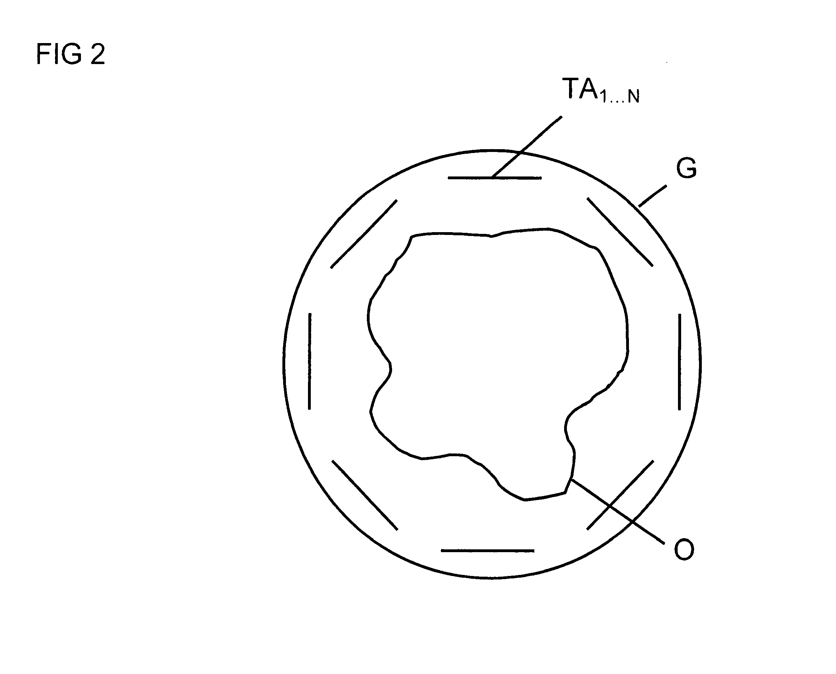

In **Fig. 1** ist schematisch ein MR-Messsystem dargestellt, das zur Durchführung des erfindungsgemäßen Verfahrens geeignet ist. Das System enthält einen Hauptmagneten **M,** mit welchem das in einem Untersuchungsvolumen **V** im Wesentlichen homogene und statische Grundmagnetfeld erzeugt wird. Dieses Untersuchungsvolumen V umgebend, sind in die Bohrung des Hauptmagneten M drei Sätze von Gradientenspulen **GX, GY,** und **GZ** eingebracht, mit denen zusätzliche, zeitlich und räumlich variable Magnetfelder kontrollierbarer Dauer und Stärke dem Grundfeld überlagert werden können. Mit Gradientenverstärkern **AX, AY** und **AZ,** die von einer Sequenzsteuereinheit **SEQ** zur zeitrichtigen Erzeugung von Gradientenpulsen angesteuert werden, werden die Gradientenspulen GX, GY, GZ mit elektrischem Strom zur Erzeugung von Gradientenfeldern versorgt. Bisher in Routineanwendungen verwendete Gradientenspulen erzeugen im Allgemeinen lineare Magnetfelder mit räumlich konstanten Gradienten. Neuartige Gradientenkonzepte verwenden dagegen auch Gradienten mit nichtlinearem Verlauf. In diesem Ausführungsbeispiel wird jedoch von den üblichen linearen Gradientenfeldern ausgegangen, die sich im k-Raum-Formalismus beschreiben lassen.
Innerhalb des Gradientensystems befinden sich mehrere (N) HF-Sendeantennen **TA$_1$** bis **TA$_N$,** die in ihrer Gesamtheit auch als Sendeantennenarray bezeichnet werden. Sie umgeben ein Untersuchungsobjekt **O** und werden von mehreren unabhängigen HF-Leistungssendern **TX$_1$** bis **TX$_N$** gespeist. Die von diesen Sendern erzeugten HF-Pulse werden von der Sequenzsteuereinheit SEQ bestimmt und zeitrichtig ausgelöst. Mit den HF-Sendeantennen TA$_1$ bis TA$_N$ werden HF-Pulse auf das im Untersuchungsvolumen V befindliche Untersuchungsobjekt O eingestrahlt, und bewirken dort eine Anregung von Kernspins. **Fig. 2** zeigt ein hierzu geeignetes HF-Sendeantennenarray mit Arrayelementen TA$_{1...N}$, die innerhalb eines Gehäuses **G** angeordnet sind. Die dadurch hervorgerufenen Magnetresonanzsignale werden mit einer oder mehreren (M) HF-Empfangsantennen **RA$_1$,.., RA$_M$,** die in ihrer Gesamtheit auch als Empfangsantennenarray bezeichnet werden, sich ebenfalls innerhalb der Gradientenspulen GX, GY, GZ befinden und das Untersuchungsobjekt O umgeben, in elektrische Spannungssignale umgesetzt, die dann in eine entsprechende Anzahl von Empfangseinheiten **RX$_1$** bis **RX$_M$** eingespeist werden. Zur Verringerung des apparativen Aufwandes kann das Antennensystem so ausgelegt und angeschlossen werden, dass eine oder mehrere der HF-Sendeantennen TA$_1$ bis TA$_N$ auch zum Empfang der Magnetresonanzsignale genutzt werden. In einem solchen Fall, der in Fig. 1 nicht berücksichtigt ist, wird mittels einer bzw. mehrerer von der Sequenzsteuereinheit SEQ kontrollierter elektronischer Sende-Empfangsweichen für eine Umschaltung zwischen Sende- und Empfangsbetrieb gesorgt, d. h. dass während der HF-Sende-Perioden der ausgeführten Pulssequenz diese Antenne(n) mit dem bzw. den entsprechenden HF-Leistungssendern verbunden und von dem bzw. den zugeordneten Empfangskanälen getrennt ist/sind, während für die Empfangs-Perioden eine Senderabtrennung und eine Empfangskanalverbindung vorgenommen wird. Mit den in Fig. 1 dargestellten Empfangseinheiten $RX_1$ bis $RX_M$ werden die empfangenen Signale verstärkt, unter Verwendung bekannter Signalverarbeitungsverfahren in digitale Signale gewandelt und diese an das elektronische Rechnersystem **COMP** weitergeleitet. Neben der Rekonstruktion von Bildern aus den empfangenen Messdaten dient das Steuerrechnersystem COMP dazu, das gesamte MR-Messsystem zu bedienen und die Ausführung der Pulssequenzen durch entsprechende Kommunikation mit der Sequenzsteuereinheit SEQ zu initiieren. Die benutzergeführte oder automatische Ausführung von Programmen zur Justage der Messsystemeigenschaften und/oder zur Erzeugung von Magnetresonanzbildern erfolgt ebenso auf diesem Steuerrechnersystem COMP wie die Darstellung der rekonstruierten Bilder und die Speicherung und Verwaltung der Mess- und Bilddaten und der Steuerprogramme. Für diese Aufgaben ist dieses Rechnersystem mindestens mit einem Prozessor, einem Arbeitsspeicher, einer Computertastatur **KB,** einem Zeigeinstrument **PNTR,** z. B. einer Computermaus, einem Bildschirm **MO** und einer externen digitalen Speichereinheit **DSK** ausgerüstet.

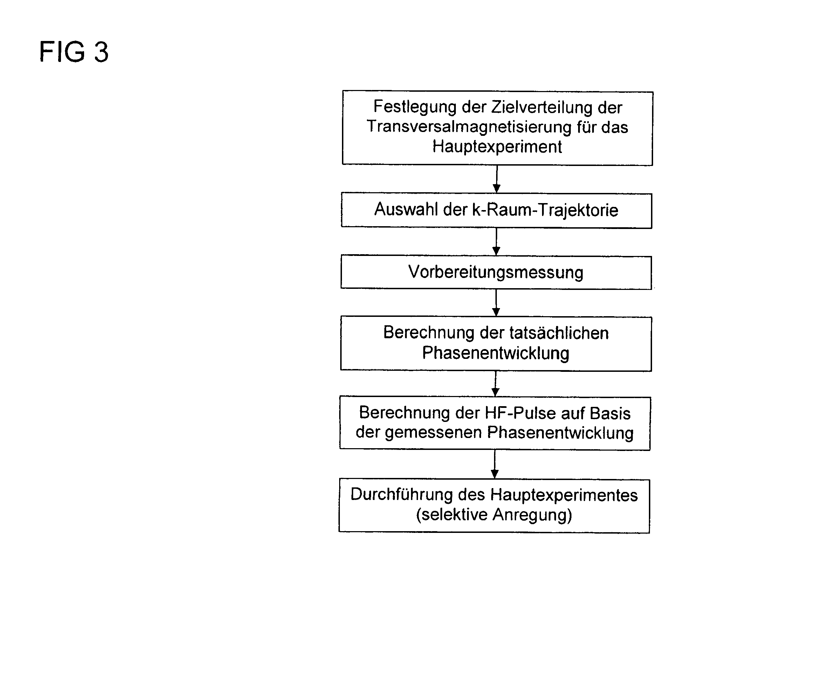

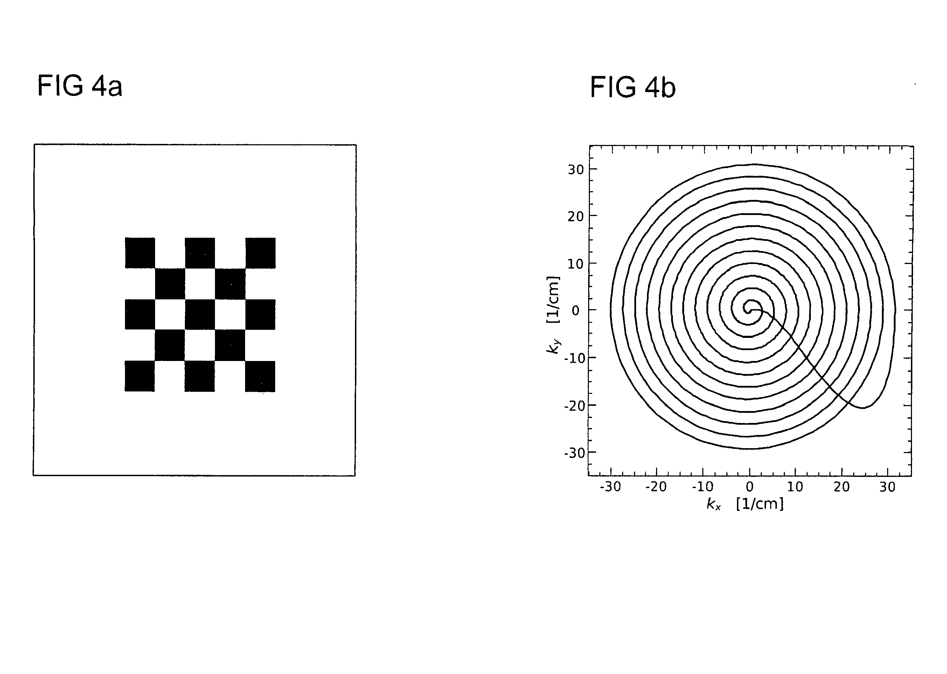

In **Fig. 3** ist ein möglicher Messablauf dargestellt. Der Messablauf beginnt zunächst damit, eine Zielverteilung der Transversalmagnetisierung zu definieren, wie sie von einem oder mehrern HF-Pulsen im Rahmen einer selektiven Anregung erzeugt werden soll. Beispielhaft wird hier ein schachbrettartiges Muster verwendet, wie es in **Fig. 4** a dargestellt ist. Zusätzlich wird eine dem Problem angepasste k-Raum-Trajektorie ausgewählt. Da im vorliegenden Beispiel eine zweidimensional räumlich selektive Anregung erfolgen soll, wird eine spiralförmige k-Raum-Trajektorie, wie sie in **Fig. 4 b** dargestellt ist, verwendet.

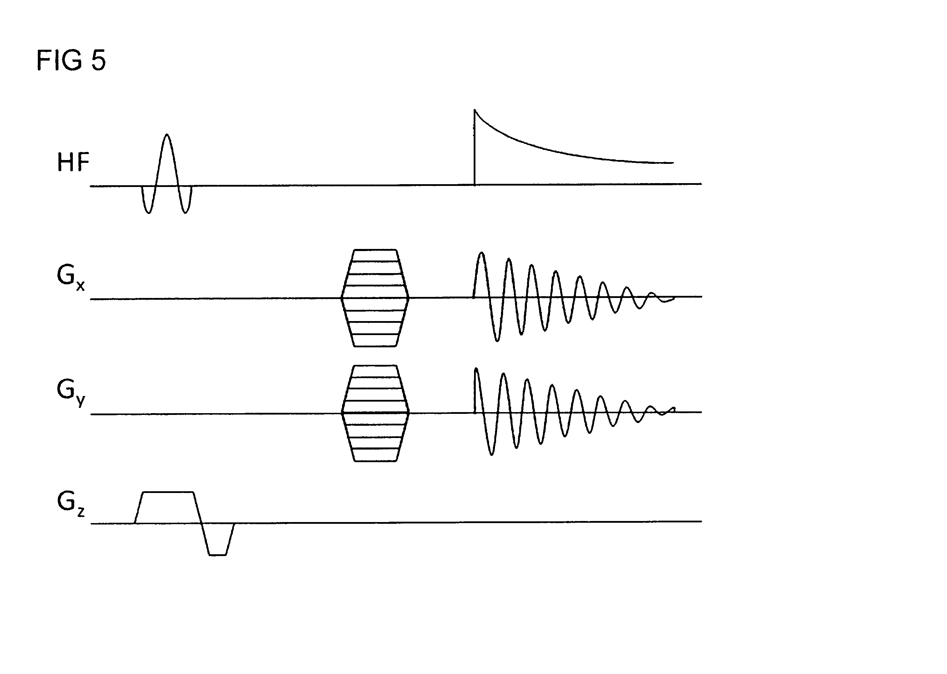

In der nun folgenden Vorbereitungsmessung werden sowohl die Effekte der zur Realisierung dieser gewählten k-Raum-Trajektorie applizierten beabsichtigten Zusatzmagnetfelder sowie alle Effekte unbeabsichtigter Zusatzmagnetfelder auf die Phasenentwicklung der Transversalmagnetisierung bestimmt. **Fig. 5** zeigt schematisch und beispielhaft einem möglichen Ablauf eines solchen Experimentes in Anlehnung an die Methode von Papadakis et al. [13]:

Ein herkömmlicher, schichtselektiver Anregungspuls erzeugt Transversalmagnetisierung in der Schicht, in der später die selektive Anregung erfolgen soll. In diesem Beispiel handelt es sich dabei um eine axiale Schicht in der x-y-Ebene im Zentrum des z-Gradienten. Das aus dieser Schicht stammende Signal wird wie üblich bei Bildgebungsexperimenten (für die Datenakquisition) ortskodiert, indem durch das kurzzeitige Anlegen von Gradientenfeldern in x- und y-Richtung der Transversalmagnetisierung eine bestimmte, ortsabhängige Phase aufgeprägt wird (nicht zu verwechseln mit der Ortskodierung und Phasenentwicklung im Sendefall). Anschließend wird die Signalaufzeichnung mit mindestens einer Empfangsantenne gestartet, während simultan die zu vermessenden Gradientenfelder in x- und y-Richtung, zur Erzeugung der für den späteren Sendefall verwendeten k-Raum-Trajektorie, angelegt werden. Das Experiment wird beispielsweise insgesamt 64x64 mal wiederholt, wobei die zur Ortskodierung des akquirierten MR-Signals verwendeten Phasenschritte durch Variation der Gradientenpulsamplitude variiert werden, bis die Daten eines vollständigen Akquisitions-k-Raumes aufgenommen sind.

Dabei sollte sichergestellt sein, dass die während der Ortskodierung zu einem Bildpunkt zusammengefassten Volumina ausreichend klein sowie die Bandbreiten der bei der Signalaufzeichnung verwendeten Filter ausreichend groß sind, so dass keine Signalauslöschung durch Dephasierung der Magnetisierung oder Präzessionsfrequenzen außerhalb des Filterbereiches auftreten.

Soll die Vorbereitungsmessung nicht nur in einer Schicht, sondern in einem dreidimensionalen Volumen durchgeführt werden, wird statt des schichtselektiven Anregungspulses ein globaler, auf das gesamte Objekt wirkender HF-Puls verwendet und es werden zur Ortskodierung in der dritten Richtung (hier die z-Richtung) zusätzliche Gradienten geschaltet.

Die Anregung in der Vorbereitungsmessung erfolgte in diesem Beispiel mit einem Antennenarray bestehend aus acht Antennen, deren einzelne Sendephasen so gewählt wurden, dass sich die Sendefelder im Antennenarray-Zentrum konstruktiv überlagern. Wie in der Beschreibung von Fig. 1 genannt, wurden im Empfangsfall dieselben Antennen des Antennenarrays verwendet.

Der so aufgezeichnete Datensatz enthält pro Empfangsantenne ein bis drei (hier: zwei) Ortsdimensionen sowie eine Dimension der Zeit, entlang welcher das MR-Signal während der Wirkung der Zusatzmagnetfelder aufgezeichnet wurde. Nach Dekodierung der vor der Akquisition erfolgten Ortskodierung, was im Allgemeinen durch eine Fouriertransformation des Datensatzes in Richtung der (Akquisitions-k-) Raumdimensionen erfolgt, können bei Verwendung mehrerer Empfangsantennen die MR-Signale der einzelnen Elemente auf die jeweilige Phase des ersten Datenpunktes normiert und gemittelt werden. Danach liegt für jeden Bild- bzw. Ortspunkt die zeitliche Phasenentwicklung vor, die sowohl während der Vorbereitungsmessung durchlaufen wurde als auch während der späteren selektiven Anlegung durchlaufen wird.

Wie bereits beschrieben, kann die benötigte Messzeit zur Aufnahme der Daten in der Vorbereitungsmessung deutlich verkürzt werden, indem mehrere Antennen zum Empfang und anschließend Rekonstruktionstechniken der parallelen Bildgebung verwendet werden.

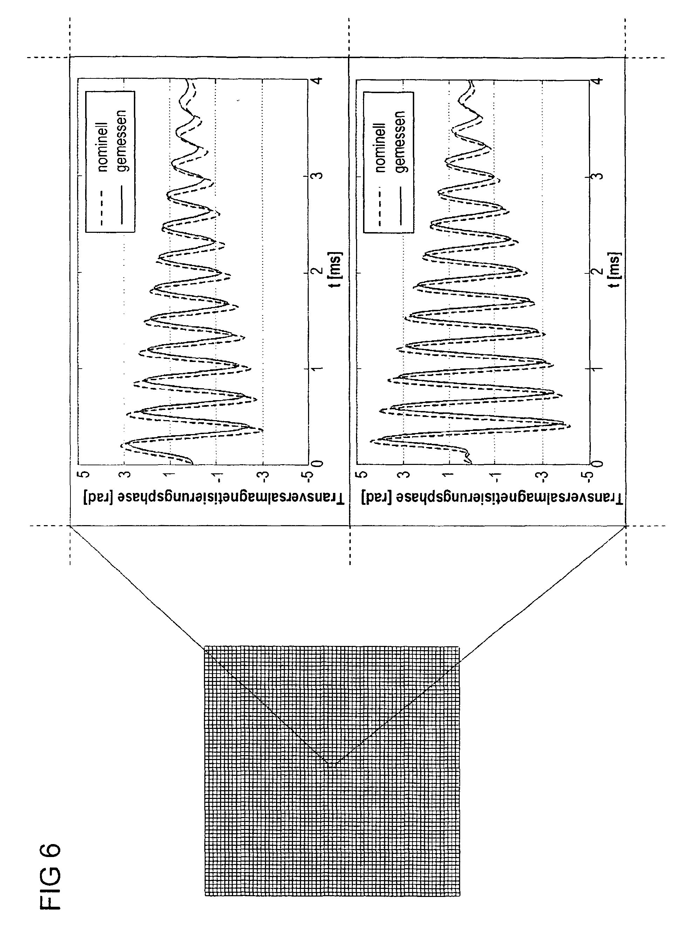

**Fig. 6** zeigt die gemessenen Phasenverläufe exemplarisch an zwei Positionen mit den x-y-Koordinaten (1 mm/0mm) und (1mm/1mm) mit dem Koordinatenursprung im Zentrum des Gradientensystems. Dabei sind sowohl berechnete Werte, die bei Annahme des exakten Durchlaufens der nominellen k-Raum-Trajektorie erwartet werden, als auch die tatsächlich gemessenen Werte als Ergebnis der Vorbereitungsmessung dargestellt. Eine Diskrepanz zwischen erwarteten und gemessenen Werten ist deutlich ersichtlich. Auf Basis der nominellen k-Raum-Trajektorie berechnete HF-Pulse würden daher nicht zu der tatsächlich durchlaufenen Phasenentwicklung passen, was in der Regel zu Artefakten und Ungenauigkeiten in der erzeugten Verteilung der Transversalmagnetisierung führt.

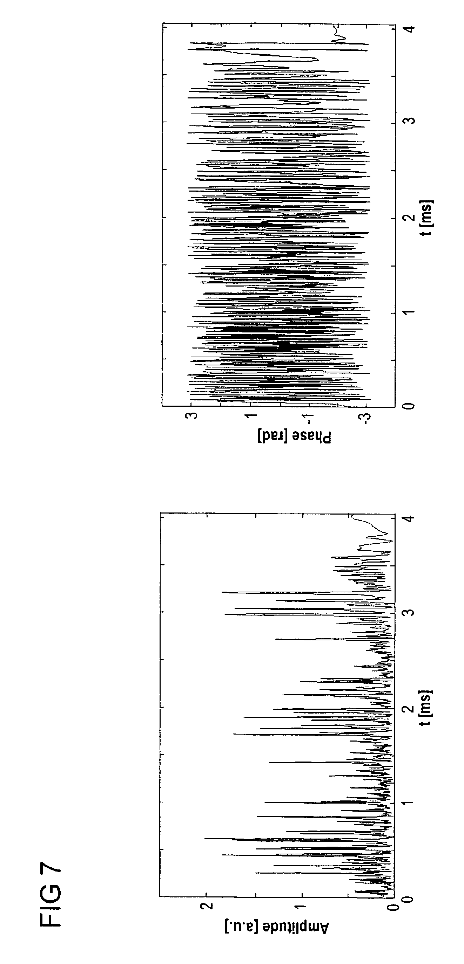

Daher werden nun zur Pulsberechnung die in der Vorbereitungsmessung ortsaufgelöst ermittelten Phasenentwicklungen für die Variable $\varphi(\mathbf{x},t)$ in Gleichung (2) eingesetzt. Hierbei kann davon ausgegangen werden, dass die Transversalmagnetisierung auch im später durchzuführenden Experiment der selektiven Anregung eine identische Phasenentwicklung durchläuft wie während der Vorbereitungsmessung. Auf dieser Basis wird schließlich die Berechnung von die Zielverteilung der Transversalmagnetisierung anregenden HF-Pulsen gestartet, indem, wie beschrieben, analog zum Verfahren von Grissom et al. [9] die Gleichung gelöst bzw. approximiert wird. In diesem Beispiel erhält man acht HF-Pulse mit individuellen Amplituden und Phasenverläufen, die während des Experimentes der selektiven Anregung mit acht Sendekanälen und -antennen dem Objekt appliziert werden. Exemplarisch sind die berechneten Amplituden- und Phasenverläufe des HF-Pulses, der dem ersten Sendekanal zugewiesen wird, in **Fig. 7** dargestellt.

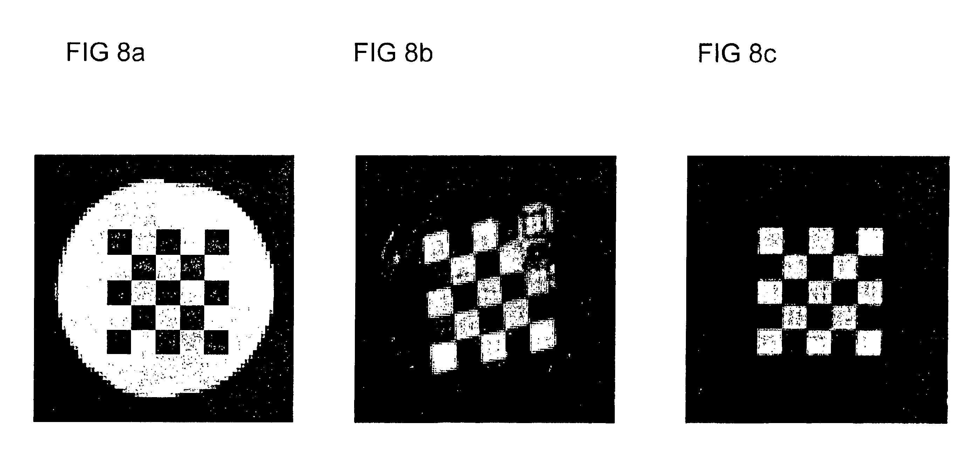

Die Vorteilhaftigkeit des erfindungsgemäßen Verfahrens wird in Fig. 8 deutlich:

**Fig. 8a** zeigt ein MR-Bild einer als anzuregendes Objekt verwendeten, wassergefüllten Kunststoffkugel, überlagert mit der angestrebten Zielverteilung der Transversalmagnetisierung. Verwendet man während der Berechnung der die Zielverteilung anzuregenden HF-Pulse lediglich die nominelle k-RaumTrajektorie und appliziert diese HF-Pulse anschließend im Hauptexperiment, während die Abweichungen zwischen erwarteter und tatsächlicher Phasenentwicklung aus Fig. 6 weiterhin vorhanden sind, ist das Ergebnis eine gestörte Anregung, wie sie **Fig. 8b** zeigt. Die Orientierung und Ausdehnung der erzeugten Transversalmagnetisierungsverteilung, ihre Geometrie sowie ihre Schärfe weichen deutlich von der vorgegebenen Verteilung ab.

Erst wenn die Pulsberechnung entsprechend dem erfindungsgemäßen Verfahren auf Basis der gemessenen lokalen Phasenentwicklung erfolgt, werden die Abweichungen in die HF-Puls-Berechnung integriert und trotz weiteren Vorhandenseins während der Anregung kompensiert. Es ergibt sich im anschließenden Experiment der selektiven Anregung eine sehr gute Übereinstimmung zwischen angeregter und vorgegebener Transversalmagnetisierungsverteilung, wie **Fig. 8c** veranschaulicht.

Das erfindungsgemäße Verfahren ermöglicht somit durch die ortsaufgelöste Messung von im Experiment durchlaufenen Phasenentwicklungen die Bestimmung von für die ein- oder mehrkanalige selektive Anregung geeigneten HF-Pulsen, wobei experimentelle Imperfektionen berücksichtigt und kompensiert werden.

**Bezugszeichenliste**

| | |
|---|---|
| A | Arrayelement |
| AX, AY, AZ | Gradientenverstärker |
| COMP | Rechnersystem |
| DSK | Speichereinheit |
| G | Gehäuse |
| GX, GY, GZ | Gradientenspulen |
| $G_x, G_y, G_z$ | Gradientenfelder |
| KB | Computertastatur |
| M | Hauptmagnet |
| MO | Bildschirm |
| O | Untersuchungsobjekt |
| PNTR | Zeigeinstrument |
| $RA_{1...M}$ | HF-Empfangsantennen |
| $RX_{1...M}$ | Empfangseinheiten |
| SEQ | Sequenzsteuereinheit |
| $TA_{1...N}$ | HF-Sendeantennen |
| $TX_{1...N}$ | HF-Leistungssender |
| V | Untersuchungsvolumen |

**Referenzen**

[1] Pauly, J. ; Nishimura, D.; Macovski A.: A k-space analysis of small-tip-angle excitation. In: Journal of Magnetic Resonance 81 (1989), S. 43-56

[2] Katscher U.; Börnert, P.; Leussler, C.; van den Brink, J. S.: Transmit SENSE. In: Magnetic Resonance in Medicine 49 (2003), S. 144-150.

[3] Meyer, C. H.; Pauly, J. M.; Macovski, A.; Nishimura, D. G.: Simultaneous spatial and spectral selective excitation. In: Magnetic Resonance in Medicine 15 (1990), S. 287-304.

[4] Setsompop, K.; Alagappan, V.; Gagoski, B.; Wald, L.; Adalsteinsson, E.: Uniform Wideband Slab Selection with B1+ Mitigation at 7T via Parallel Spectral-Spatial Excitation. In: Proceedings 16th Scientific Meeting, International Society for Magnetic Resonance in Medicine (2008), 616.

[5] Schomberg, H.; Börnert, P.: Off-resonance correction of nD spatially selective RF pulses. In: Proceedings 6th Scientific Meeting, International Society for Magnetic Resonance in Medicine, Sydney, 1998, S. 2059

[6] Börnert, P.; Aldefeld, B.: On spatially selective RF excitation and its analogy with spiral MR image acquisition. In: Magnetic Resonance Materials in Physics, Biology and Medicinee 7 (1998), S. 166-178

[7] Xu, D.; King, K. F.; Zhu, Y. D.; McKinnon, G. C.; Liang, Z. P.: A noniterative method to design large-tip-angle multidimensional spatially-selective radio frequency pulses for parallel transmission. In: Magnetic Resonance in Medicine 58 (2007), S. 326-334.

[8] Yip, C.-Y.; Fessler, J. A.; Noll, D. C.: Iterative RF pulse design for multidimensional, small-tip-angle selective excitation. In: Magnetic Resonance in Medicine 54 (2005), S. 908-917

[9] Grissom, W.; Yip, C.-Y.; Zhang, Z.; Stenger, V. A.; Fessler, J. A.; Noll, D. C.: Spatial domain method for the design of RF pulses in multicoil parallel excitation. In: Magnetic Resonance in Medicine 56 (2006), S. 620-629

[10] Ullmann, P.; Haas, M.; Hennel, F.; Wick, M.; Voiron, J.; Zaitsev, M.; Hennig, J.; Ruhm, W.: Parallel Excitation Experiments Using Measured k-Space Trajectories for Pulse Calculation. In: Proceedings 16th Scientific Meeting, International Society for Magnetic Resonance in Medicine (2008), 1313.

[11] Duyn, J. H. ; Yang, Y.; Frank, J. A.; van der Veen, J. W.: Simple correction method for k-space trajectory deviations in MRI. In: Journal of Magnetic Resonance 132 (1998), S. 150-153.

[12] DE 10 2005 051 021 A1; Hennig, J.: Apparaturen und Verfahren zur kernspintomographischen Aufnahme mit lokalen Magnetfeldgradienten in Verbindung mit lokalen Empfangsspulen.

[13] Papadakls, N. G.; Wilkinson, A. A.; Carpenter T. A.; Hall, L. D.: A general method for measurement of the time integral of variant magnetic field gradients: application to 2D spiral imaging. In: Magnetic Resonance Imaging 15 (1997), S. 567-578.

[14] Haas, M.; Kokorin, D.; Ullmann, P.; Schneider, J.T.; Hennig, J.; Zaitsev, M.: T2*-compensated Transmit SENSE RF pulses. Zur Veröffentlichung angenommen in: Proceedings 17th Scientific Meeting, International Society for Magnetic Resonance in Medicine (2009), 2589.

[15] Zhang, Y. et al.: "A NOVEL K-SPACE TRAJECTORY MEASUREMENT TECHNIQUE" MAGNETIC RESONANCE IN MEDICINE, ACADEMIC PRESS, DULUTH, MN, US, Bd. 39, 1. Juni 1998 (1998-06-01), Seiten 999-1004.

[16] Oelhafen, M. et al: "Calibration of echo-planar 2D-selective RF excitation pulses" MAGNETIC RESONANCE IN MEDICINE, ACADEMIC PRESS, DULUTH, MN, US, Bd. 52, 2004, Seiten 1136-1145.

[17] Takahashi, A. Peters, T.: compensation of multi-dimensional selective excitation pulses using measured k-space trajectories" MAGNETIC RESONANCE IN MEDICINE, ADACEMIC PRESS, DULUTH, MN, US, Bd. 34, 1995, Seiten 446-456.

**Patentansprüche**

1. Verfahren zur Ermittlung von Amplituden- und Phasenverläufen von Hochfrequenzpulsen, welche im Rahmen eines Hauptexperimentes der magnetischen Resonanz zur Erzeugung einer vorgegebenen n-dimensionalen räumlichen Verteilung mit n>=1 der Transversalmagnetisierung in einem Objekt mittels mindestens einer Hochfrequenz-Sendeantenne eines Magnetresonanzmesssystems in Kombination mit dem Einwirken räumlich und zeitlich variierender, dem statischen und homogenen Grundfeld des Magnetresonanzmesssystems überlagerter Zusatzmagnetfelder, die zu einer ortsabhängigen, zeitlichen Änderung der Transversalmagnetisierungsphase im Objekt führen, eingestrahlt werden, wobei vor Durchführung des Hauptexperimentes eine Vorbereitungsmessung in Form einer MR-Messung durchgeführt wird und die Amplituden- und Phasenverläufe der Hochfrequenzpulse für das Hauptexperiment auf Basis der Vorbereitungsmessung berechnet werden, und
wobei der räumliche und zeitliche Verlauf der Zusatzmagnetfelder während der Vorbereitungsmessung und dem Hauptexperiment im Wesentlichen identisch sind,
**dadurch gekennzeichnet,**
**dass** bei der Vorbereitungsmessung die zeitliche Änderung der Transversalmagnetisierungsphase im Objekt unter Einwirkung der Zusatzmagnetfelder ortsaufgelöst gemessen wird, und
**dass** die Amplituden- und Phasenverläufe der Hochfrequenzpulse für das Hauptexperiment direkt, d.h. ohne die Berechnung einer für das ganze Objekt global gültigen k-Raum-Trajektorie, auf Basis dieser ortsaufgelöst gemessenen zeitlichen Änderung der Transversalmagnetisierungsphase gerade so berechnet werden, daß im Hauptexperiment die vorgegebene u-dimensionale Verteilung der Transversalmagnetisierung erreicht wird.

2. Verfahren nach Anspruch 1, **dadurch gekennzeichnet, dass** die Zusatzmagnetfelder aus beabsichtigten und unbeabsichtigten Komponenten bestehen und das Verfahren zur mindestens partiellen Kompensation von Effekten unbeabsichtigter Komponenten der Zusatzmagnetfelder auf die im Hauptexperiment erzeugte Transversalmagnetisierungsverteilung verwendet wird.

3. Verfahren nach Anspruch 1 oder 2, **dadurch gekennzeichnet, dass** die Zusatzmagnetfelder aus beabsichtigten und unbeabsichtigten Komponenten bestehen, und die beabsichtigten Komponenten der Zusatzmagnetfelder räumlich konstante Gradienten innerhalb des Objektes aufweisen.

4. Verfahren nach Anspruch 1 oder 2, **dadurch gekennzeichnet, dass** die Zusatzmagnetfelder aus beabsichtigten und unbeabsichtigten Komponenten bestehen, und die beabsichtigten Komponenten der Zusatzmagnetfelder räumlich nichtkonstante Gradienten innerhalb des Objektes aufweisen.

5. Verfahren nach einem der Ansprüche 1 bis 4, **dadurch gekennzeichnet, dass** bei der Berechnung der Amplituden- und Phasenverläufe der Hochfrequenzpulse eine Kleinwinkelnäherung angewendet wird.

6. Verfahren nach einem der Ansprüche 1 bis 4, **dadurch gekennzeichnet, dass** bei der Berechnung der Amplituden- und Phasenverläufe der Hochfrequenzpulse keine Kleinwinkelnäherung angewendet wird.

7. Verfahren nach einem der vorhergehenden Ansprüche, **dadurch gekennzeichnet, dass** das Objekt mindestens zwei Kernspinensembles mit voneinander verschiedenen Präzessionsfrequenzen enthält, wobei jedes Kernspinensemble einen Beitrag zur Transversalmagnetisierung leistet, und dass für mindestens einen dieser Beiträge eine zu erzeugende n-dimensionale räumliche Verteilung mit n>=1 vorgegeben wird.

8. Verfahren nach Anspruch 7, **dadurch gekennzeichnet, dass** in der Vorbereitungsmessung die Phasenentwicklung der Transversalmagnetisierung von nur einer spektralen Komponente des Objektes gemessen wird.

9. Verfahren nach einem der vorhergehenden Ansprüche, **dadurch gekennzeichnet, dass** Amplituden- und Phasenverläufe von aufeinander abgestimmten HF-Pulsen berechnet werden, die beim Hauptexperiment zur Erzeugung der vorgegebenen Transversalmagnetisierungsverteilung parallel von verschiedenen Sendeantennen in das Objekt eingestrahlt werden.

10. Verfahren nach einem der vorhergehenden Ansprüche, **dadurch gekennzeichnet, dass** bei der Vorbereitungsmessung mehr als eine Empfangsantenne verwendet wird.

11. Verfahren nach einem der vorhergehenden Ansprüche, **dadurch gekennzeichnet, dass** in der Vorbereitungsmessung auch eine oder mehrere Zeitkonstanten der transversalen Relaxation der Magnetisierung des Objekts ortsaufgelöst ermittelt werden.


**Claims**

1. Method for obtaining amplitude and phase dependencies of radio frequency pulses, which are irradiated within the scope of a main magnetic resonance experiment for generating a predetermined n-dimensional spatial distribution with n>=1 of transverse magnetization into an object by means of at least one radio frequency transmitting antenna of a magnetic resonance measuring system in combination with the action of spatially and temporally varying additional magnetic fields which are superimposed on the static and homogeneous base field of the magnetic resonance measuring system and change the transverse magnetization phase in the object in dependence on location and time, wherein prior to performance of the main experiment, a preparational measurement in the form of an MR measurement is performed and the amplitude and phase dependencies of the radio frequency pulses for the main experiment are calculated on the basis of the preparational measurement, and
wherein the spatial and temporal dependency of the additional magnetic fields during the preparational measurement and the main experiment are substantially identical,
**characterized in that**
in the preparational measurement, the change with time of the transverse magnetization phase in the object under the action of the additional magnetic fields is measured in a position-resolved fashion, and the amplitude and phase dependencies of the radio frequency pulses are calculated directly, i.e. without calculating a k-space trajectory that is globally valid for the overall object, for the main experiment just in such a fashion that the predetermined n-dimensional distribution of the transverse magnetization is reached in the main experiment, on the basis of this temporal change, measured in a position-resolved fashion, of the transverse magnetization phase.

2. Method according to claim 1, **characterized in that** the additional magnetic fields consist of intentional and unintentional components and the method is used for at least partial compensation of effects of unintentional components of the additional magnetic fields on the transverse magnetization distribution generated in the main experiment.

3. Method according to claim 1 or 2, **characterized in that** the additional fields consist of intentional and unintentional components and the intentional components of the additional magnetic fields have spatially constant gradients within the object.

4. Method according to claim 1 or 2, **characterized in that** the additional fields consist of intentional and unintentional components, and the intentional components of the additional magnetic fields have spatially non-constant gradients within the object.

5. Method according to any one of the claims 1 through 4, **characterized in that** small tip angle approximation is applied for calculating the amplitude and phase dependencies of the radio frequency pulses.

6. Method according to any one of the claims 1 through 4, **characterized in that** small tip angle approximation is not applied for calculating the amplitude and phase dependencies of the radio frequency pulses.

7. Method according to any one of the preceding claims, **characterized in that** the object contains at least two nuclear spin ensembles with different precession frequencies, wherein each nuclear spin ensemble contributes to the transverse magnetization and an n-dimensional spatial distribution with n>=1 to be produced is predetermined for at least one of these contributions.

8. Method according to claim 7, **characterized in that** the phase development of the transverse magnetization is measured in the preparational measurement for only one spectral component of the object.

9. Method according to any one of the preceding claims, **characterized in that** the amplitude and phase dependencies of matched RF pulses are calculated, which are irradiated in parallel from different transmitting antennas into the object for generating the predetermined transverse magnetization distribution in the main experiment.

**10.** Method according to any one of the preceding claims, **characterized in that** more than one receiving antenna is used in the preparational measurement.

**11.** Method according to any one of the preceding claims, **characterized in that** one or more time constants of transverse relaxation of the magnetization of the object are also obtained in a position-resolved fashion in the preparational measurement.

**Revendications**

**1.** Procédé de détermination des variations d'amplitude et de phase d'impulsions à haute fréquence qui sont émises, dans le cadre d'une expérience principale de résonance magnétique pour produire une distribution spatiale n-dimensionnelle prédéfinie, avec n >= 1, de la magnétisation transversale dans un objet, au moyen d'au moins une antenne d'émission haute fréquence d'un système de mesure par résonance magnétique en combinaison avec l'action de champs magnétiques supplémentaires variables dans l'espace et le temps, superposés au champ fondamental statique et homogène du système de mesure par résonance magnétique, qui conduisent à une variation locale et temporelle de la phase de magnétisation transversale dans l'objet, une mesure préparatoire sous la forme d'une mesure par RM étant réalisée avant de réaliser l'expérience principale et les variations d'amplitude et de phase des impulsions à haute fréquence pour l'expérience principale étant calculées sur la base de la mesure préparatoire,
et
la variation dans l'espace et le temps des champs magnétiques supplémentaires étant sensiblement identique pendant la mesure préparatoire et l'expérience principale,
**caractérisé en ce**
**que** lors de la mesure préparatoire, la variation dans le temps de la phase de magnétisation transversale dans l'objet sous l'action des champs magnétiques supplémentaires est mesurée avec résolution locale, et
**que** les variations d'amplitude et de phase des impulsions à haute fréquence pour l'expérience principale sont calculées directement, c.-à-d. sans le calcul d'une trajectoire dans l'espace k valable globalement pour tout l'objet, sur la base de cette variation dans le temps, mesurée avec résolution locale, de la phase de magnétisation transversale, justement de façon que la distribution spatiale n-dimensionnelle prédéfinie de la magnétisation transversale soit atteinte dans l'expérience principale.

**2.** Procédé selon la revendication 1, **caractérisé en ce que** les champs magnétiques supplémentaires sont composés de composantes intentionnelles et non intentionnelles et le procédé est utilisé pour la compensation au moins partielle d'effets de composantes non intentionnelles des champs magnétiques supplémentaires sur la distribution de magnétisation transversale produite dans l'expérience principale.

**3.** Procédé selon la revendication 1 ou 2, **caractérisé en ce que** les champs magnétiques supplémentaires sont composés de composantes intentionnelles et non intentionnelles et les composantes intentionnelles des champs magnétiques supplémentaires présentent des gradients constants dans l'espace à l'intérieur de l'objet.

**4.** Procédé selon la revendication 1 ou 2, **caractérisé en ce que** les champs magnétiques supplémentaires sont composés de composantes intentionnelles et non intentionnelles et les composantes intentionnelles des champs magnétiques supplémentaires présentent des gradients non constants dans l'espace à l'intérieur de l'objet.

**5.** Procédé selon l'une des revendications 1 à 4, **caractérisé en ce qu'**on applique une approximation des petits angles pour calculer les variations d'amplitude et de phase des impulsions à haute fréquence.

**6.** Procédé selon l'une des revendications 1 à 4, **caractérisé en ce qu'**on n'applique pas une approximation des petits angles pour calculer les variations d'amplitude et de phase des impulsions à haute fréquence.

**7.** Procédé selon l'une des revendications précédentes, **caractérisé en ce que** l'objet contient au moins deux ensembles de spins nucléaires avec des fréquences de précession différentes l'une de l'autre, chaque ensemble de spins nucléaires apportant une contribution à la magnétisation transversale, et que, pour au moins une de ces contributions, une distribution spatiale n-dimensionnelle à produire, avec n >= 1, est prédéfinie.

**8.** Procédé selon la revendication 7, **caractérisé en ce que** dans la mesure préparatoire, on mesure l'évolution de phase de la magnétisation transversale de seulement une composante spectrale de l'objet.

**9.** Procédé selon l'une des revendications précédentes, **caractérisé en ce qu'**on calcule les variations d'amplitude et de phase d'impulsions HF accordées les unes aux autres qui, dans l'expérience principale, sont émises dans l'objet par différentes antennes d'émission en parallèle pour produire la distribution de magnétisation transversale prédéfinie.

**10.** Procédé selon l'une des revendications précédentes, **caractérisé en ce que** plus d'une antenne de réception est utilisée lors de la mesure préparatoire.

**11.** Procédé selon l'une des revendications précédentes, **caractérisé en ce qu'**une ou plusieurs constantes de temps de la relaxation transversale de la magnétisation de l'objet sont aussi déterminées avec résolution locale dans la mesure préparatoire.

FIG 1

EP 2 237 060 B1

FIG 2

EP 2 237 060 B1

FIG 3

```
┌─────────────────────────────────┐
│   Festlegung der Zielverteilung der  │
│   Transversalmagnetisierung für das  │
│         Hauptexperiment          │
└─────────────────────────────────┘
                 │
                 ▼
┌─────────────────────────────────┐
│    Auswahl der k-Raum-Trajektorie    │
└─────────────────────────────────┘
                 │
                 ▼
┌─────────────────────────────────┐
│        Vorbereitungsmessung         │
└─────────────────────────────────┘
                 │
                 ▼
┌─────────────────────────────────┐
│     Berechnung der tatsächlichen     │
│         Phasenentwicklung          │
└─────────────────────────────────┘
                 │
                 ▼
┌─────────────────────────────────┐
│    Berechnung der HF-Pulse auf Basis   │
│    der gemessenen Phasenentwicklung   │
└─────────────────────────────────┘
                 │
                 ▼
┌─────────────────────────────────┐
│   Durchführung des Hauptexperimentes   │
│         (selektive Anregung)         │
└─────────────────────────────────┘
```

EP 2 237 060 B1

FIG 4b

FIG 4a

EP 2 237 060 B1

FIG 5

FIG 6

FIG 7

FIG 8c

FIG 8b

FIG 8a

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005051021 A1, Hennig, J.

**In der Beschreibung aufgeführte Nicht-Patentliteratur**

- **PAULY, J. ; NISHIMURA, D. ; MACOVSKI A.** A k-space analysis of small-tip-angle excitation. *Journal of Magnetic Resonance,* 1989, vol. 81, 43-56
- **KATSCHER U. ; BÖRNERT, P. ; LEUSSLER, C. ; VAN DEN BRINK, J. S.** Transmit SENSE. *Magnetic Resonance in Medicine,* 2003, vol. 49, 144-150
- **MEYER, C. H. ; PAULY, J. M. ; MACOVSKI, A. ; NISHIMURA, D. G.** Simultaneous spatial and spectral selective excitation. *Magnetic Resonance in Medicine,* 1990, vol. 15, 287-304
- **SETSOMPOP, K. ; ALAGAPPAN, V ; GAGOSKI, B ; WALD, L. ; ADALSTEINSSON, E.** Uniform Wideband Slab Selection with B1+ Mitigation at 7T via Parallel Spectral-Spatial Excitation. *Proceedings 16th Scientific Meeting, International Society for Magnetic Resonance in Medicine,* 2008, 616
- **SCHOMBERG, H ; BÖRNERT, P.** Off-resonance correction of nD spatially selective RF pulses. *Proceedings 6th Scientific Meeting, International Society for Magnetic Resonance in Medicine, Sydney,* 1998, 2059
- **BÖRNERT, P. ; ALDEFELD, B.** On spatially selective RF excitation and its analogy with spiral MR image acquisition. *Magnetic Resonance Materials in Physics, Biology and Medicinee,* 1998, vol. 7, 166-178
- **XU, D. ; KING, K. F. ; ZHU, Y. D. ; MCKINNON, G. C. ; LIANG, Z. P.** A noniterative method to design large-tip-angle multidimensional spatially-selective radio frequency pulses for parallel transmission. *Magnetic Resonance in Medicine,* 2007, vol. 58, 326-334
- **YIP, C.-Y. ; FESSLER, J. A. ; NOLL, D. C.** Iterative RF pulse design for multidimensional, small-tip-angle selective excitation. *Magnetic Resonance in Medicine,* 2005, vol. 54, 908-917

- **GRISSOM, W. ; YIP, C.-Y. ; ZHANG, Z. ; STENGER, V. A. ; FESSLER, J. A. ; NOLL, D. C.** Spatial domain method for the design of RF pulses in multicoil parallel excitation. *Magnetic Resonance in Medicine,* 2006, vol. 56, 620-629
- **ULLMANN, P. ; HAAS, M. ; HENNEL, F. ; WICK, M. ; VOIRON, J. ; ZAITSEV, M. ; HENNIG, J. ; RUHM, W.** Parallel Excitation Experiments Using Measured k-Space Trajectories for Pulse Calculation. *Proceedings 16th Scientific Meeting, International Society for Magnetic Resonance in Medicine,* 2008, 1313
- **DUYN, J. H. ; YANG, Y ; FRANK, J. A. ; VAN DER VEEN, J. W.** Simple correction method for k-space trajectory deviations in MRI. *Journal of Magnetic Resonance,* 1998, vol. 132, 150-153
- **PAPADAKLS, N. G. ; WILKINSON, A. A ; CARPENTER T. A ; HALL, L. D.** A general method for measurement of the time integral of variant magnetic field gradients: application to 2D spiral imaging. *Magnetic Resonance Imaging,* 1997, vol. 15, 567-578
- **HAAS, M. ; KOKORIN, D. ; ULLMANN, P. ; SCHNEIDER, J.T ; HENNIG, J. ; ZAITSEV, M.** T2*-compensated Transmit SENSE RF pulses. Zur Veröffentlichung angenommen. *Proceedings 17th Scientific Meeting, International Society for Magnetic Resonance in Medicine,* 2009, 2589
- A NOVEL K-SPACE TRAJECTORY MEASUREMENT TECHNIQUE. **ZHANG, Y. et al.** MAGNETIC RESONANCE IN MEDICINE. ACADEMIC PRESS, 01. Juni 1998, vol. 39, 999-1004
- Calibration of echo-planar 2D-selective RF excitation pulses. **OELHAFEN, M. et al.** MAGNETIC RESONANCE IN MEDICINE. ACADEMIC PRESS, 2004, vol. 52, 1136-1145
- compensation of multi-dimensional selective excitation pulses using measured k-space trajectories. **TAKAHASHI, A. ; PETERS, T.** MAGNETIC RESONANCE IN MEDICINE. ADACEMIC PRESS, 1995, vol. 34, 446-456